# EUROPÄISCHE PATENTSCHRIFT

(11) **EP 1 493 184 B1**
(45) Veröffentlichungstag und Bekanntmachung des Hinweises auf die Patenterteilung: **14.12.2005**
(21) Anmeldenummer: 03735379.4
(22) Anmeldetag: 13.05.2003
(51) Int. Cl.: H01L 21/8222, H01L 27/082, H01L 21/8249, H01L 27/06

(54) **VERFAHREN ZUM HERSTELLEN EINER INTEGRIERTEN SCHALTUNG UND INTEGRIERTE SCHALTUNG MIT EINEM BIPOLARTRANSISTOR UND EINEM HETEROBIPOLARTRANSISTOR**
METHOD FOR THE PRODUCTION OF AN INTEGRATED CIRCUIT AND INTEGRATED CIRCUIT WITH A BIPOLAR TRANSISTOR AND A HETERO BIPOLAR TRANSISTOR
PROCEDE DE PRODUCTION D'UN CIRCUIT INTEGRE ET CIRCUIT INTEGRE POURVU D'UN TRANSISTOR BIPOLAIRE ET D'UN TRANSISTOR HETERO-BIPOLAIRE

(30) Priorität: 14.05.2002 DE 10221416
(43) Veröffentlichungstag der Anmeldung: 05.01.2005
(73) Patentinhaber: Infineon Technologies AG, 81669 München (DE)
(72) Erfinder: DAHL, Claus, 01109 Dresden (DE); MUELLER, Karlheinz, 84149 Velden (DE); WAGNER, Cajetan, 01099 Dresden (DE)
(74) Vertreter: Schoppe, Fritz
(86) Internationale Anmeldenummer: PCT/EP2003/005001
(87) Internationale Veröffentlichungsnummer: WO 2003/096412

(56) Entgegenhaltungen:
- EP-A- 1 117 133
- GB-A- 2 362 508
- US-A- 5 523 606
- US-A1- 2001 008 298
- US-B1- 6 169 007

## Beschreibung

Die vorliegende Erfindung bezieht sich auf integrierte Schaltungen und insbesondere auf eine integrierte Schaltung, die einen Bipolartransistor und einen Heterobipolartransistor umfaßt.

Bipolartransistoren, also Transistoren aus materialmäßig homogenem Halbleitermaterial sind bekannt und umfassen einen Kollektor, eine Basis und einen Emitter. Im Falle eines npn-Transistors ist der Kollektor aus einem n-dotierten Halbleitermaterial gebildet, ist die Basis aus einem p-dotierten Halbleitermaterial gebildet, und ist der Emitter aus einem n-dotierten Halbleitermaterial gebildet.

Eine Spezies eines solchen npn-Bipolartransistors (BT) ist der sogenannte Doppel-Poly-Silizium-Bipolartransistor in selbstausrichtender Technologie.

In der Technik ferner bekannt ist der Heterobipolartransistor (HBT), der in der technologischen Herstellung kritischer als der konventionelle Bipolartransistor ist. Ein Heterobipolartransistor ist ebenfalls eine npn- oder pnp-Struktur, wobei jedoch das Basismaterial ein anderes Halbleitermaterial als das Material des Emitters und des Kollektors ist. Wenn z. B. von einem SiGe-Heterobipolartransistor gesprochen wird, so bedeutet dies üblicherweise, daß das Substrat, der Kollektor und der Emitter des HBT aus Silizium gebildet sind, während die Basis aus Silizium-Germanium gebildet ist. Ein Beispiel für einen Silizium-Germanium-Heterobipolartransistor (HBT) ist der Doppel-Poly-SiGe-HBT in selbstausrichtender Technik mit selektiv epitaxial aufgewachsener Basis.

Weiterhin ist in der Technik die sogenannte BiCMOS-Technologie bekannt, bei der auf einer integrierten Schaltung konventionelle Bipolartransistoren mit CMOS-Invertern integriert sind, wobei ein CMOS-Inverter aus einem n-Kanal-FET und einem p-Kanal-PET besteht.

US-A-5 523 606 offenbart eine integrierte Schaltung mit CMOSFETS, Bipolartransistoren und Heterobipolartransistoren.

US-A1-2001/0008298 offenbart Bipolar- und Heterobipolartransistoren mit hochdotierten Kollektor. bereichen.

Klassische Bipolartransistoren zeigen in der Herstellung einen guten Ertrag, d. h. die Herstellungsschritte für klassische Bipolartransistoren werden gut beherrscht. Nachteilig an klassischen Bipolartransistoren im Vergleich zu Heterobipolartransistoren ist die Tatsache, daß sie stärker rauschen als Heterobipolartransistoren, und daß sie geringere Grenzfrequenzen haben. Insbesondere für rauscharme hochfrequente Anwendungen wird daher ein Heterobipolartransistor einem normalen Bipolartransistor vorgezogen.

Andererseits hat ein klassischer Bipolartransistor aufgrund der gut beherrschbaren Technologie ein gutes Matching-Verhalten. Ist beispielsweise ein Stromspiegel aus Transistoren aufzubauen, so sollen zwei Transistoren möglichst identisch sein, also gut aneinander angepaßt oder "gematched" sein. In anderen Worten soll das Matching-Verhalten dieser beiden Transistoren möglichst hoch sein. Aus der integrierten Schaltungstechnik ist es bekannt, daß im Falle eines schlechteren Matching-Verhaltens, wie es bei Heterobipolartransistoren auftritt, dieses schlechtere Matching-Verhalten dadurch kompensiert werden kann, daß die Transistoren insgesamt größer gemacht werden, was in einem höheren Chipflächenverbrauch resultiert. In anderen Worten ausgedrückt können Schaltungen aus Bipolartransistoren daher kleiner und chipflächensparender integriert werden. Wesentlicher ist jedoch der Nachteil des HBT, daß der Ertrag, also die Anzahl von funktionsfähigen Transistoren pro Wafer im Vergleich zum Ertrag bei klassischen Bipolartransistoren deutlich reduziert ist.

Insbesondere bei Sende/Empfangs-Modulen für tragbare Telephone oder andere Funkanwendungen werden an bestimmten Stellen besonders rauscharme und schnelle Transistoren benötigt, wie z. B. in der ersten Stufe des HF-Eingangsverstärkers. Andererseits wird an anderer Stelle in diesem integrierten Sender-Empfangs-Modul die Rauscheigenschaft des Transistors nicht so wesentlich sein, sondern eher die Anforderung, daß mehrere Transistoren möglichst identisch aufgebaut werden können, wie z. B. bei einem symmetrischen Mischer zum Abwärtsmischen des HF-Empfangssignals ins Basisband. Darüber hinaus ist im Basisband die Schnelligkeit bzw. Grenzfrequenz des Transistors nicht von wesentlicher Bedeutung. Eher von Bedeutung ist hier eine verläßliche Charakteristik für das Verhalten des Transistors und natürlich auch der Chipflächenverbrauch und nicht zuletzt die Kosten.

Die Kosten für ein Einzelmodul steigen jedoch mit abnehmendem Ertrag, so daß eine Herstellung eines Sende/Empfangs-Moduls allein unter Verwendung von klassischen Bipolartransistoren zwar einen guten Ertrag und einen geringen Chipflächenverbrauch hat, jedoch hinsichtlich der Grenzfrequenz und des Rauschverhaltens gegenüber einer vollständigen Implementierung des Moduls mit HBTs zurückfällt, während die HBT-Integration einen höheren Chipflächenverbrauch und einen geringeren Ertrag, also höhere Kosten verursacht.

Die Aufgabe der vorliegenden Erfindung besteht darin, eine preisgünstige integrierte Schaltung mit guten elektrischen Charakteristika und ein Verfahren zum Herstellen der integrierten Schaltung zu schaffen.

Diese Aufgabe wird durch ein Verfahren zum Herstellen.einer integrierten Schaltung nach Patentanspruch 1 oder durch eine integrierte Schaltung nach Patentanspruch 16 gelöst.

Die erfindungsgemäße integrierte Schaltung umfaßt ein Halbleitersubstrat, einen Bipolartransistor in dem Halbleitersubstrat und einen Heterobipolartransistor in dem Halbleitersubstrat, wobei die beiden Transistoren derart integriert sind, daß möglichst viele Herstellungsschritte sowohl für die klassische Bipolartechnik als auch die Heterobipolartechnik gemeinsam verwendet werden können. Die erfindungsgemäße integrierte Schaltung zeichnet sich dadurch aus, daß die Kollektorstruktur für den Bipolartransistor und den Heterobipolartransistor aus identischen Schichten des Halbleitersubstrats gebildet sind, und/oder daß die Emitterstrukturen des Bipolartransistors und des Heterobipolartransistors aus identischen Schichten des Halbleitersubstrats gebildet sind.

Die gemeinsame Verwendung derselben Schichten als Kollektorstruktur für einen Bipolartransistor einerseits und einen Heterobipolartransistor andererseits wird dadurch möglich gemacht, daß in einem Basisbereich des Heterobipolartransistors eine Platzhalterschicht erzeugt wird, wobei die Platzhalterschicht in einem Basisbereich des Bipolartransistors nicht vorhanden ist. Dann kann die Basis des Bipolartransistors erzeugt werden, ohne daß besondere Maßnahmen für den Basisbereich des Heterobipolartransistors getroffen werden müssen, da die Platzhalterschicht eine Beeinflussung des Basisbereichs des Heterobipolartransistors durch die Schritte zur Herstellung der Basis des Bipolartransistors verhindert. Nach der Herstellung de Basis des Bipolartransistors wird diese dann abgedeckt, wobei ferner die Platzhalterschicht entfernt wird, um dann in dem Bereich, aus dem die Platzhalterschicht entfernt worden ist, die Basis des Heterobipolartransistors aus dem zweiten Halbleitermaterial, wie z. B. Silizium-Germanium, zu erzeugen. Nach der Erzeugung der Basis, die vorzugsweise durch selektives epitaxiales Aufwachsen von Silizium-Germanium erzeugt wird, sind dann sowohl der Bipolartransistor als auch der Heterobipolartransistor auf der integrierten Schaltung im gleichen Zustand, derart, daß die Emitterstruktur für den Bipolartransistor und den Heterobipolartransistor unter Verwendung derselben Prozeßschritte erzeugt werden kann.

Das erfindungsgemäße Konzept zeichnet sich dadurch aus, daß möglichst viele Herstellungsschritte sowohl für den Bipolartransistor als auch für den Heterobipolartransistor gleich sind. Insbesondere können sowohl die Kollektorstruktur als auch die Emitterstruktur für beide Transistoren unter Verwendung derselben Schritte erzeugt werden.

Ein Vorteil der vorliegenden Erfindung besteht darin, daß nun Bipolartransistoren mit HBTs kostengünstig in eine integrierte Schaltung integriert werden können. Insbesondere für Anwendungen, wie z. B. Sende/Empfangs-Module, bei denen an unterschiedlichen Stellen in der Schaltung Charakteristika von Bipolartransistoren und Charakteristika von Heterobipolartransistoren benötigt werden, kann dann tatsächlich nur an der Stelle, wo ein Heterobipolartransistor unbedingt benötigt wird, derselbe verwendet werden, während an anderen Stellen normale Bipolartransistoren verwendet werden können.

Die Schaltung hat damit insgesamt ein gutes elektrisches Verhalten, da die Rauscharmut und die hohe Grenzfrequenz der Heterobipolartransistoren ausgenutzt werden kann, während gleichzeitig der Ertrag der Schaltung hoch ist, da nur möglichst wenig Heterobipolartransistoren verwendet werden, so daß der insgesamte Ertrag hoch gehalten werden kann, da der Ertrag mit zunehmender Anzahl von Heterobipolartransistoren auf einer Schaltung abnehmen würde. Andererseits kann Chipfläche eingespart werden, da die guten Matching-Eigenschaften der normalen Bipolartransistoren ausgenutzt werden können, und zwar ebenfalls dort in der Schaltung, wo es tatsächlich nötig ist.

Das erfindungsgemäße Konzept der Integration von Bipolartransistoren und Heterobipolartransistoren in einer integrierten Schaltung, wobei die beiden Transistorarten in ihrer Kollektorstruktur und/oder ihrer Emitterstruktur gleich sind, was durch die Verwendung der Platzhalterschicht möglich wird, kann somit einerseits eine preisgünstige Schaltung erzeugt, die andererseits dort wo es tatsächlich nötig ist, günstige elektrische Eigenschaften hat, die durch die ertragskritischen und chipflächenintensiven Heterobipolartransistoren dominiert werden. Ein weiterer Vorteil der vorliegenden Erfindung besteht darin, daß das Integrationskonzept zum Integrieren von Bipolartransistoren und Heterobipolartransistoren mit einem CMOS-Prozeßkonzept kompatibel ist, so daß auf der integrierten Schaltung ferner CMOS-Schaltungen zusätzlich integrierbar sind.

Bevorzugte Ausführungsbeispiele der vorliegenden Erfindung werden nachfolgend Bezug nehmend auf die beiliegenden Zeichnungen detailliert erläutert. Es zeigen:
- Fig. 1: einen Querschnitt durch eine integrierte Schaltung nach einem ersten Lithographieschritt zum Herstellen von Ausrichtungsmarken;
- Fig. 2: einen Querschnitt durch eine integrierte Schaltung nach einem Lithographieschritt zum Implantieren einer vergrabenen N-Schicht sowohl im Bipolar-Bereich als auch im CMOS-Bereich;
- Fig. 3: einen Querschnitt durch eine integrierte Schaltung nach einer Ausdiffusion der Implantationsbereiche;
- Fig. 4: einen Querschnitt durch eine integrierte Schaltung nach einem Epitaxieschritt;
- Fig. 5: einen Querschnitt durch eine integrierte Schaltung nach einem Lithographieschritt zum Definieren von Gräben für den Transistorbereich;
- Fig. 6: einen Querschnitt durch eine integrierte Schaltung nach einem Ätzen der Isolationsgräben für den Transistorbereich;
- Fig. 7: einen Querschnitt durch eine integrierte Schaltung nach einem Füllen der Gräben;
- Fig. 8: einen Querschnitt durch eine integrierte Schaltung nach einem Lithographieschritt zum Definieren der aktiven Gebiete im Bipolarbereich und im CMOS-Bereich;
- Fig. 9: einen Querschnitt durch eine integrierte Schaltung nach dem chemisch-mechanischen Polieren (CMP);
- Fig. 10: einen Querschnitt durch eine integrierte Schaltung nach einem Lithographieschritt zum Definieren des Kollektorkontakts der Bipolartransistoren;
- Fig. 11: einen Querschnitt durch eine integrierte Schaltung nach einem Lithographieschritt zum Definieren von p-Bereichen als CMOS-Wannen und als Isolationsgebiete;
- Fig. 12: einen Querschnitt durch eine integrierte Schaltung nach einem Lithographieschritt zum Definieren des n-Bereichs im CMOS-Bereich der integrierten Schaltung;
- Fig. 13: einen Querschnitt durch eine integrierte Schaltung nach einem Lithographieschritt zum Bearbeiten der Basisbereiche sowohl des npn-Bipolartransistors (BT) als auch des Heterobipolartransistors (HBT);
- Fig. 14: einen Querschnitt durch eine integrierte Schaltung nach einer Öffnung des Basisbereichs sowohl des npn-Bipolartransistors als auch des Heterobipolartransistors;
- Fig. 15: einen Querschnitt durch eine integrierte Schaltung nach einem Lithographieschritt zum Definieren der Platzhalterschicht im Basisbereich des HBT;
- Fig. 16: einen Querschnitt durch eine integrierte Schaltung nach einem Aufwachsen der oberen Polysiliziumschicht;
- Fig. 17: einen Querschnitt durch eine integrierte Schaltung nach einem Ätzen der Gate-Kontakte im CMOS-Bereich und der Basisanschlüsse im Bipolarbereich;
- Fig. 18: einen Querschnitt durch eine integrierte Schaltung nach einem Lithographieschritt zum Implantieren des Polysilizium-Basisanschlußbereichs im Bipolarbereich;
- Fig. 19: einen Querschnitt durch eine integrierte Schaltung nach einem Lithographieschritt zum Definieren von Emitterfenstern im Bipolarbereich;
- Fig. 20: einen Querschnitt durch eine integrierte Schaltung nach der Herstellung von selektiv implantierten Kollektoren im Bipolarbereich und nach einer Herstellung der Basis des npn-Bipolartransistors;
- Fig. 21: einen Querschnitt durch eine integrierte Schaltung nach einem Lithographieschritt, der die Ätzung einer zum Ausbilden eines seitlichen Spacers im Emitterfenster des Heterobipolartransistors abgeschiedenen Schicht nur dort zuläßt und diese Schicht in allen anderen Bereichen vor der Ätzung schützt;
- Fig. 22: einen Querschnitt durch eine integrierte Schaltung nach der Spacerätzung und Entfernung der Platzhalterschicht;
- Fig. 23: einen Querschnitt durch eine integrierte Schaltung nach der selektiven Epitaxie von Silizium-Germanium in dem Bereich des Heterobipolartransistors, aus dem die Platzhalterschicht entfernt worden ist;
- Fig. 24: einen Querschnitt durch eine integrierte Schaltung nach einem Zwischenschritt zur Herstellung von Abstandshaltern in den jeweiligen Emitterfenstern im Bipolarbereich der integrierten Schaltung;
- Fig. 25: einen Querschnitt durch eine integrierte Schaltung nach einer Herstellung der Abstandshalter in den jeweiligen Emitterfenstern des Bipolarbereichs;
- Fig. 26: einen Querschnitt durch eine integrierte Schaltung nach einem Lithographieschritt zum Definieren des Emitterbereichs sowohl für den Bipolartransistor als auch für den Heterobipolartransistor;
- Fig. 27: ein Ablaufdiagramm der prinzipiellen Schritte zum erfindungsgemäßen Herstellen einer integrierten Schaltung, die klassische Bipolartransistoren und Heterobipolartransistoren umfaßt.

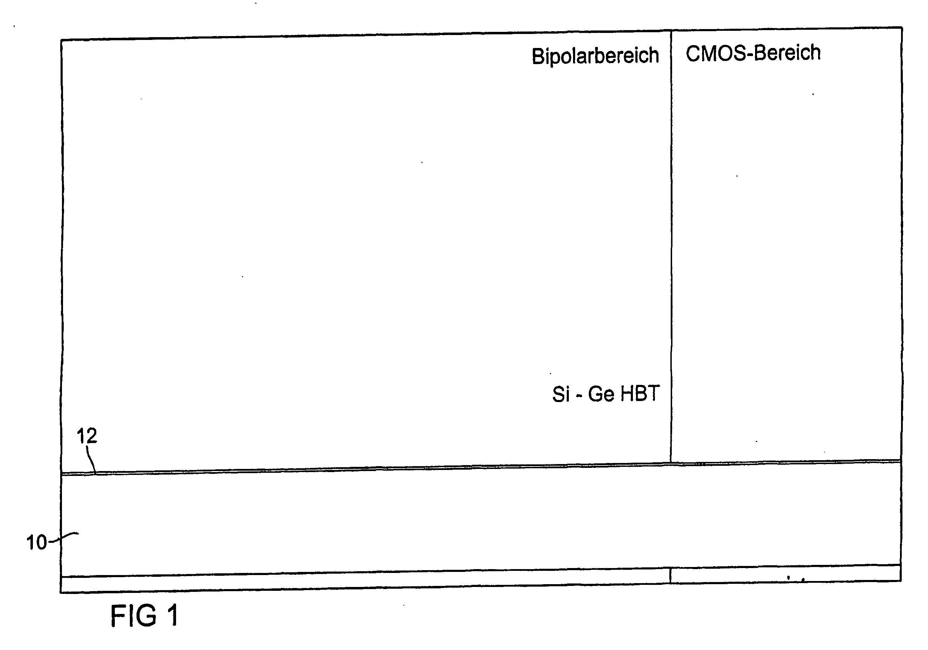

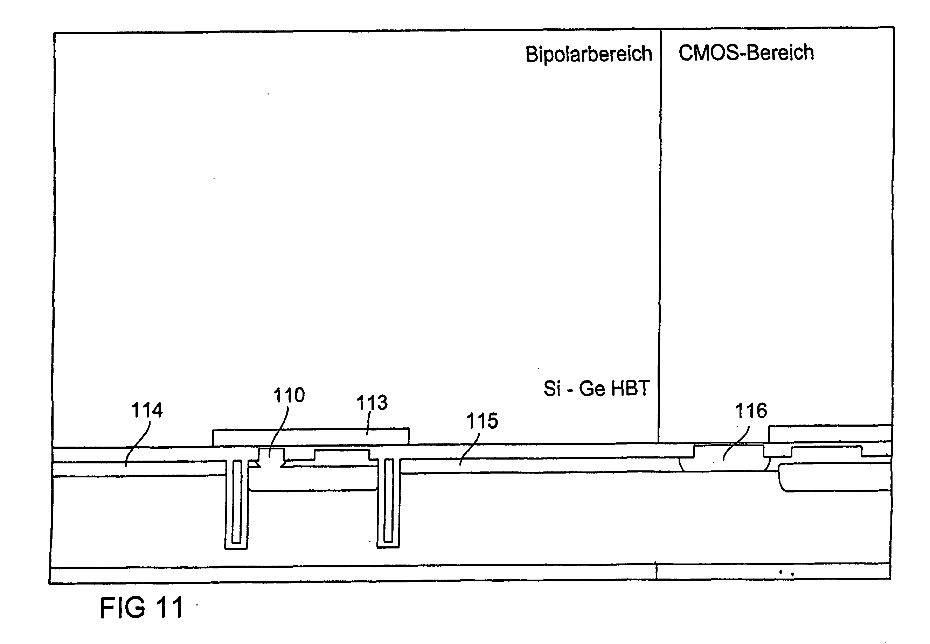

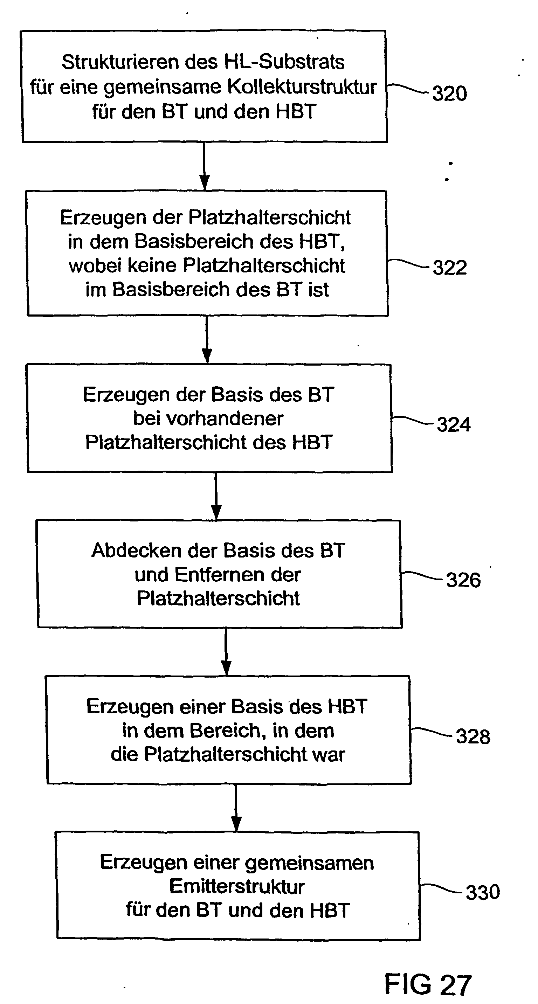

Bevor nachfolgend auf die detaillierte Prozeßfolge zum Herstellen einer erfindungsgemäßen integrierten Schaltung gemäß einem bevorzugten Ausführungsbeispiel eingegangen wird, die in den Fig. 1 bis 26 dargelegt ist, wird anhand von Fig. 27 das grundsätzliche der vorliegenden Erfindung zugrunde liegende Konzept dargestellt. Zunächst wird ein Halbleitersubstrat für eine gemeinsame Kollektorstruktur sowohl für den Bipolartransistor als auch den Heterobipolartransistor strukturiert (320). Anschließend wird die Platzhalterschicht in dem Basisbereich des Heterobipolartransistors erzeugt, wobei jedoch keine Platzhalterschicht im Basisbereich des Bipolartransistors vorhanden ist (322). Nun werden die Basis des Bipolartransistors und der Kollektor von Bipolar- und Heterobipolartransistor vorzugsweise durch Implantation und Ausheilen (Annealing) bei vorhandener Platzhalterschicht des Heterobipolartransistors erzeugt. Die Platzhalterschicht stellt sicher, daß die Implantationsatome der Basisimplantation, die auf die integrierte Schaltung geschossen werden, nicht in den Halbleiterbereich unter der Platzhalterschicht eindringen, sondern durch dieselbe aufgenommen werden. Die Kollektorimplantation durchdringt die Platzhalterschicht und wird sowohl für den Bipolartransistor als auch für den Heterobipolartransistor wirksam. Dies hat den Vorteil, daß keine Extravorkehrung für die Heterobipolartransistoren getroffen werden muß, sondern daß einfach die gesamte integrierte Schaltung, d. h. der gesamte Wafer, den Implantationsschritten unterzogen werden kann, wobei eine effektive Halbleiterimplantation mit dem Dotierstoff der Basisimplantation nur in den Basisbereichen der Bipolartransistoren stattfindet, jedoch nicht in den Basisbereichen der Heterobipolartransistoren, was auf die Platzhalterschicht zurückzuführen ist.

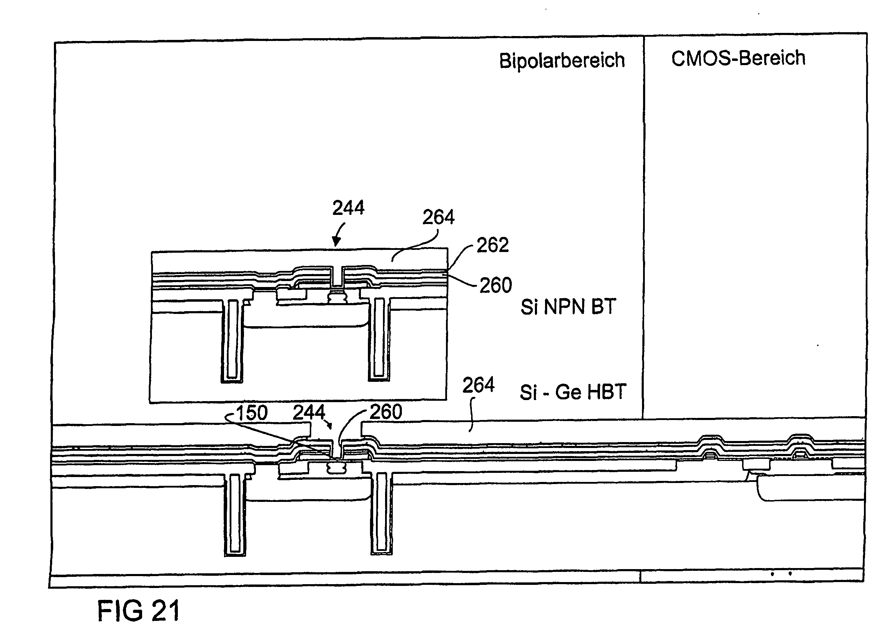

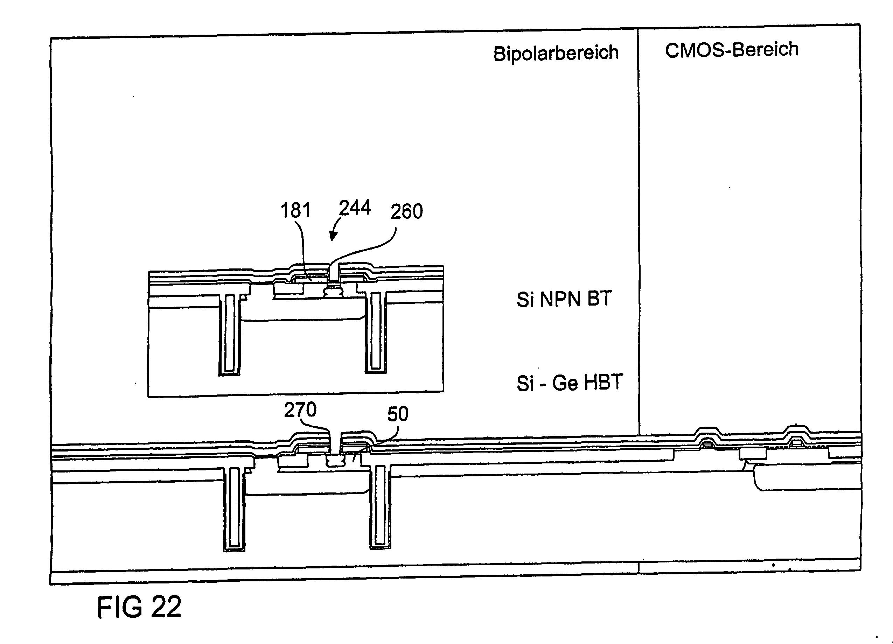

In einem Schritt 326 wird dann die Basis des Bipolartransistors abgedeckt, wobei ferner die Platzhalterschicht aus dem Basisbereich des Heterobipolartransistors entfernt wird, um in einem späteren Schritt 328 die Basis des Heterobipolartransistors in dem Bereich, in dem die Platzhalterschicht war, vorzugsweise mittels selektiver Epitaxie von z. B. SiGe auf Si zu erzeugen, wobei jedoch in dem Basisbereich des Bipolartransistors kein Aufwachsen stattfindet, was auf die Abdeckung zurückzuführen ist, die vorzugsweise als Nitridschicht (260 in Fig. 22) ausgeführt ist. Diese Nitridschicht ist die Nitridschicht, mit der die Seitenwandspacer im HBT erzeugt werden und die mittels Lithographie auf dem Rest der Scheibe abgedeckt und deshalb dort nicht geätzt wurde (vgl. Fig. 21 und Fig. 22). Im Bipolartransistor liegt unter diesem Nitrid noch das dünne Streuoxid der Basis-Implantation.

Nach dem Entfernen der Abdeckung der Basis des Bipolartransistors, also der Nitridschicht, liegen die Basisbereiche sowohl des Bipolartransistors als auch des Heterobipolartransistors frei und können erfindungsgemäß mit denselben Schritten weiterverarbeitet werden, um die einzelnen Transistoren durch Herstellen entsprechender, für beide Transistortypen gleicher Emitterstrukturen fertigzustellen (Schritt 330).

Bevor im nachfolgenden detailliert auf die einzelnen Figuren eingegangen wird, sei darauf hingewiesen, daß jede Figur der Fig. 1 bis 26 den Bipolarbereich einem CMOS-Bereich gegenüberstellt. Aus dieser Gegenüberstellung wird ersichtlich, daß viele Schritte sowohl für den Bipolarbereich als auch für den CMOS-Bereich gemeinsam verwendet werden können.

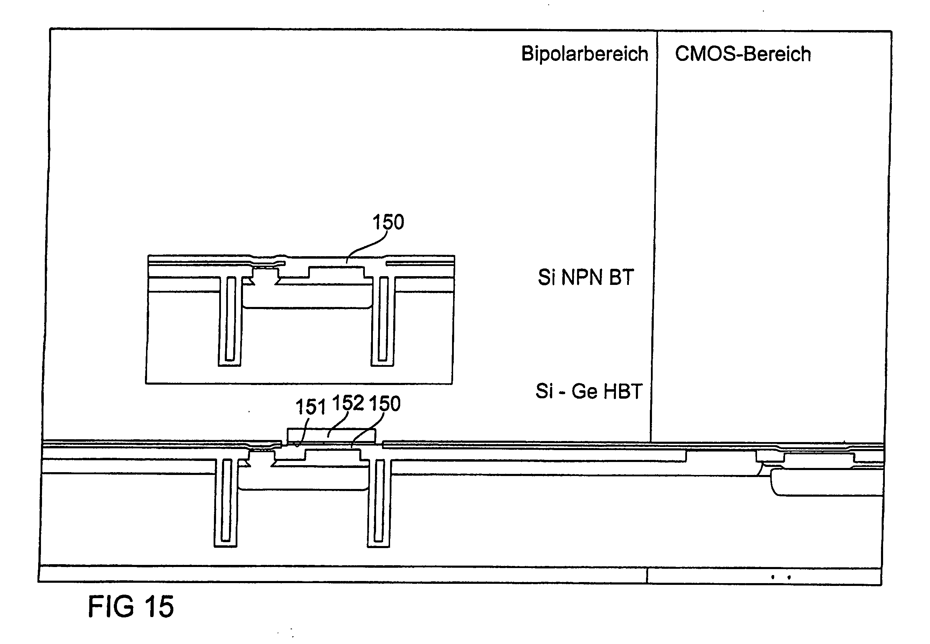

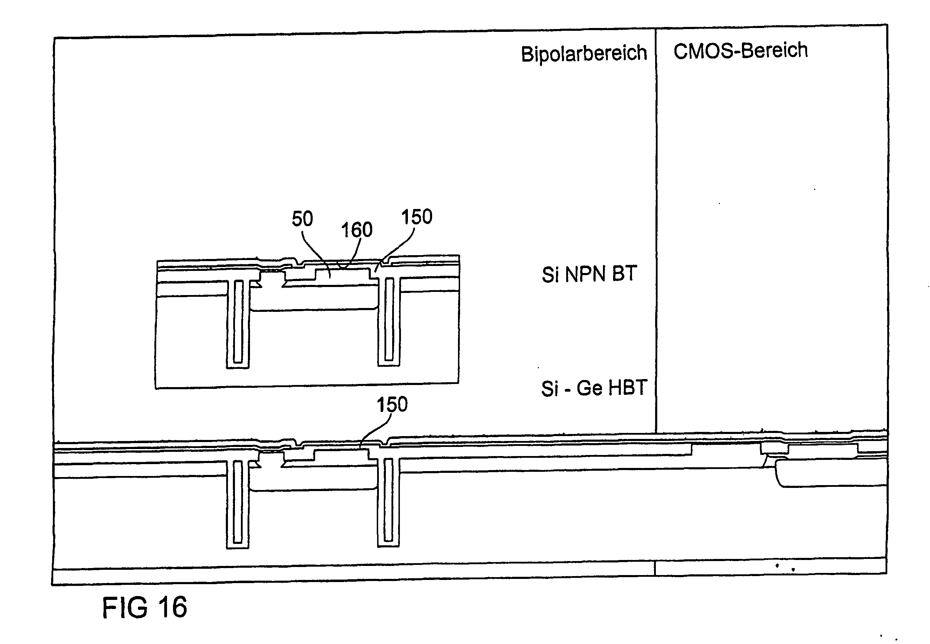

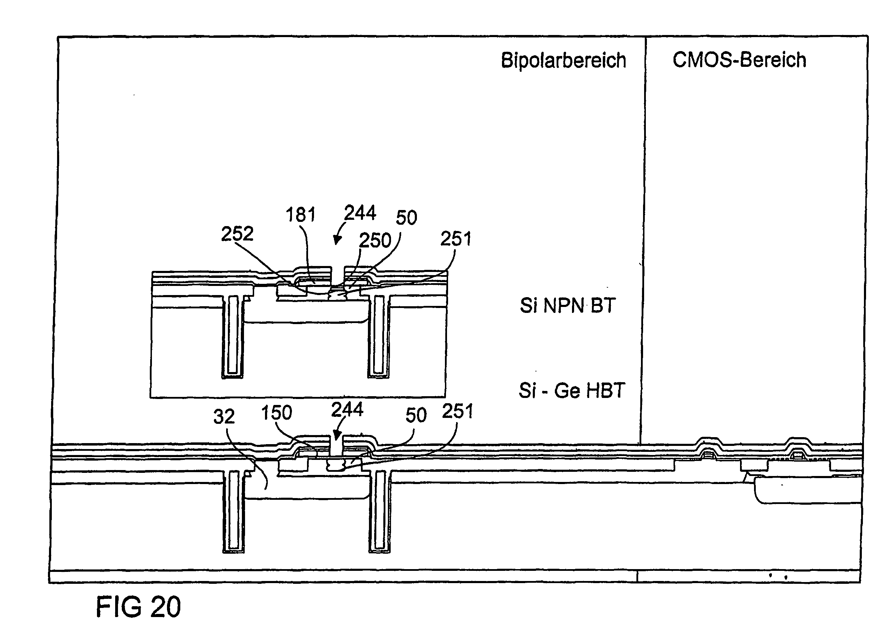

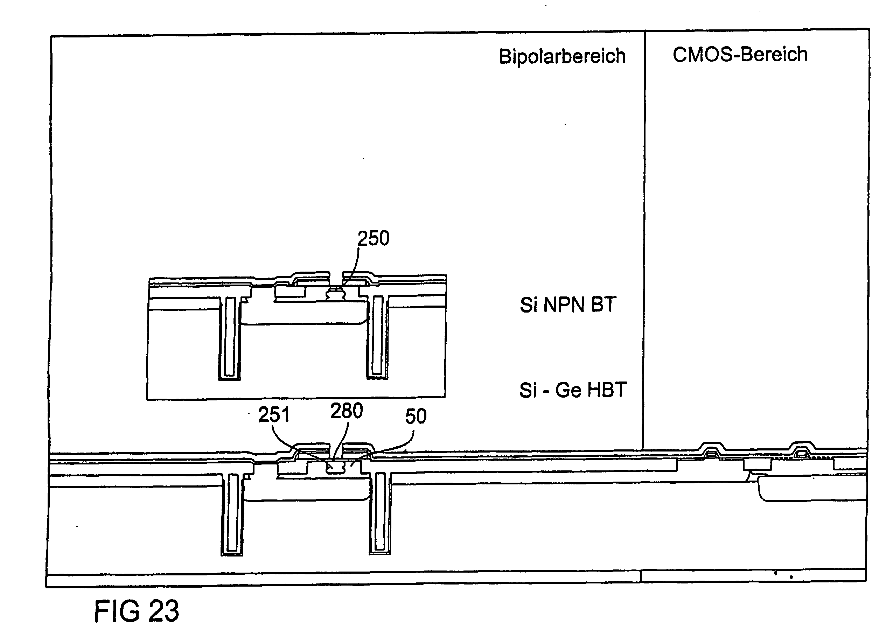

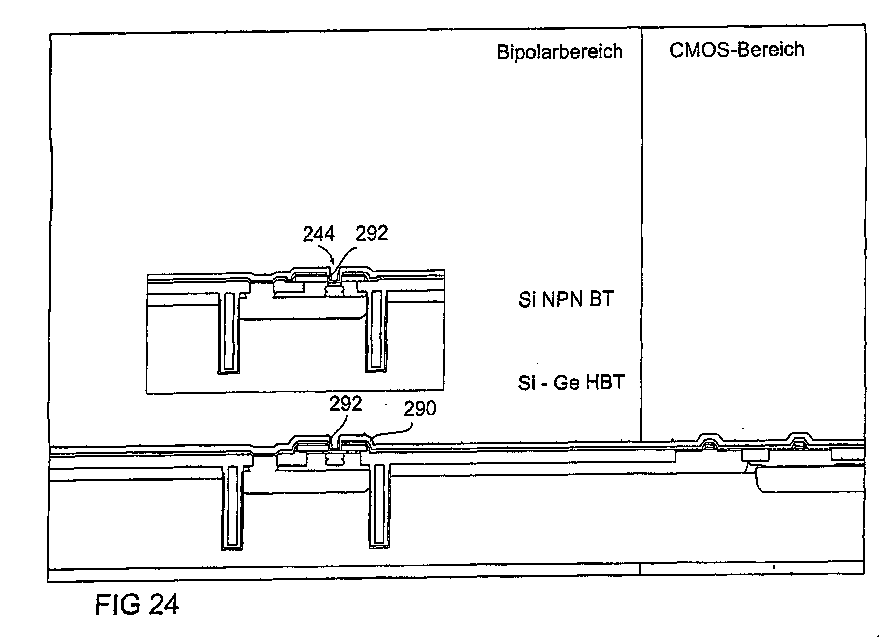

Das erfindungsgemäße Konzept unterscheidet sich in den Fig. 1 bis 14 noch nicht hinsichtlich des Heterobipolartransistors oder des klassischen npn-Transistors. In Fig. 15 wird die Erzeugung der Platzhalterschicht dargestellt. In den darauffolgenden Fig. 16 - 20 werden sowohl der npn-Transistor (BT) als auch der Si-Ge-HBT gleich behandelt, wobei jedoch die Basisimplantation, die in Fig. 20 gezeigt ist, aufgrund der Platzhalterschicht im Basisbereich des HBT nicht zum Erfolg führt. Lediglich in den Fig. 21 bis 23 wird wieder zwischen der Bearbeitung des Bipolartransistors und des HBT unterschieden, wobei diese Unterscheidung dadurch entsteht, daß die Platzhalterschicht entfernt wird, um die Basis des HBT in den Bereich einzubringen, in dem die Platzhalterschicht vorhanden war. Im Zustand der Herstellung der integrierten Schaltung, der in Fig. 23 dargestellt ist, sind die beiden Transistortypen wieder "synchron", so daß die Fertigstellung der Emitterstruktur, die in den Fig. 24 bis 26 dargestellt ist, wieder für beide Transistoren identisch durchgeführt werden kann, ohne daß Integrationsschritte vonnöten sind, die nur z. B. den npn-Transistor betreffen, die jedoch nicht den Heterobipolartransistor betreffen oder umgekehrt.

Im nachfolgenden wird auf die Fig. 1 bis 26 eingegangen, um eine durchgehende Prozeßkette gemäß einem bevorzugten Ausführungsbeispiel der vorliegenden Erfindung zum Herstellen einer integrierten Schaltung mit einem Si-npn-Bipolartransistor, einem Si-Ge-HBT und einer CMOS-Struktur darzustellen.

In Fig. 1 wird zunächst ein Ausgangssubstrat vorzugsweise in Form eines p-Substrats 10 bereitgestellt. Das Substrat wird gereinigt und dann mit einer Oxidschicht 12 versehen. Daraufhin wird in einem ersten Lithographieschritt ein Satz von Ausrichtungsmarken (Alignment Marks) definiert. Es sei darauf hingewiesen, daß entstandene Ausrichtungsmarken in Fig. 1 nicht gezeigt sind.

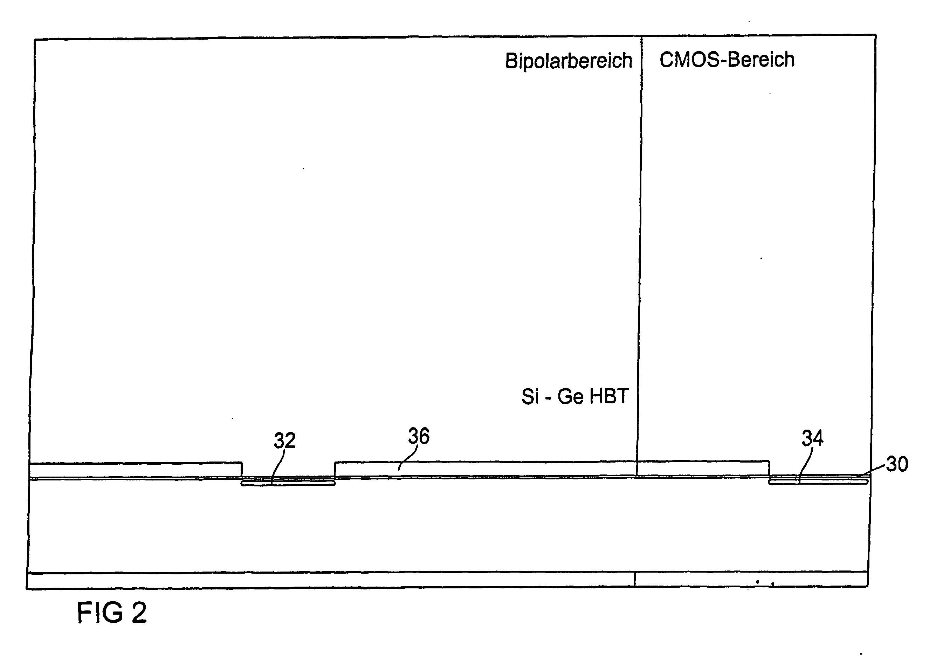

In Fig. 2 wird dann eine Naßätzung durchgeführt, um die Oxidschicht 12, die in Fig. 1 gezeigt ist, vollständig zu entfernen. Dann wird erneut oxidiert, um eine weitere Oxidationsschicht 30 zu erzeugen, die vorzugsweise eine Dicke von 15 nm hat. Dann wird ein weiterer Lithographieschritt durchgeführt, um Bereiche einer vergrabenen Schicht 32 im Bipolarbereich und 34 im CMOS-Bereich zu definieren. Die Bereiche 32 und 34 sind durch einen entsprechenden Photolack 36, der durch den Lithographieschritt aufgebracht wird, definiert. Eine Arsen-Implantation mit einer Dosis von einigen 10¹⁵ cm⁻² legt dann gewissermaßen den Grundstein für die vergrabene Schicht 32 im Bipolarbereich, die später Teil der Kollektorstruktur sein wird.

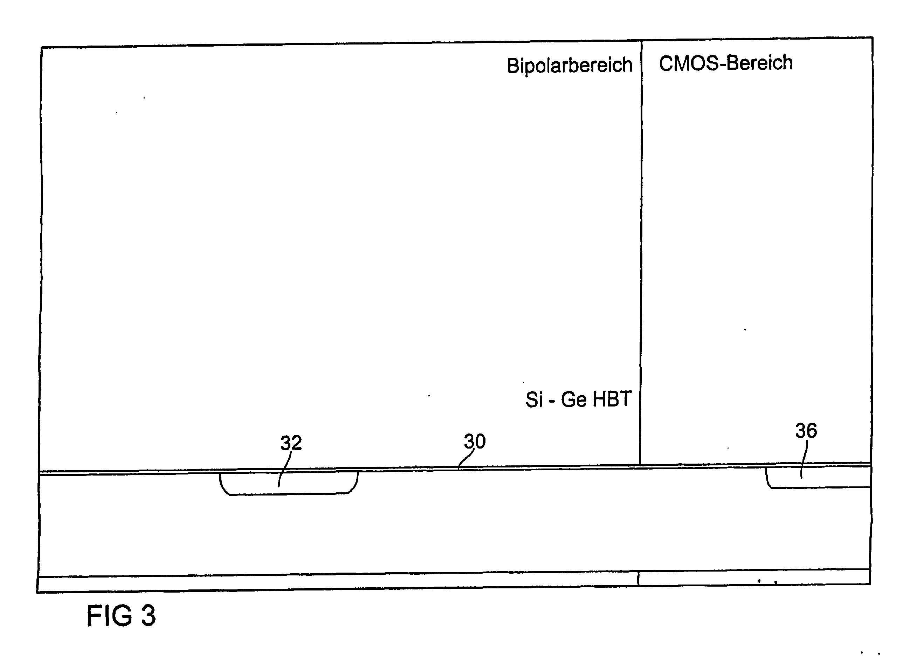

Fig. 3 zeigt einen Querschnitt durch die integrierte Schaltung, nachdem der Photolack 36 entfernt worden ist und nachdem die Implantationsgebiete 32 und 34 von Fig. 2 durch eine Temperaturbehandlung eindiffundiert worden sind.

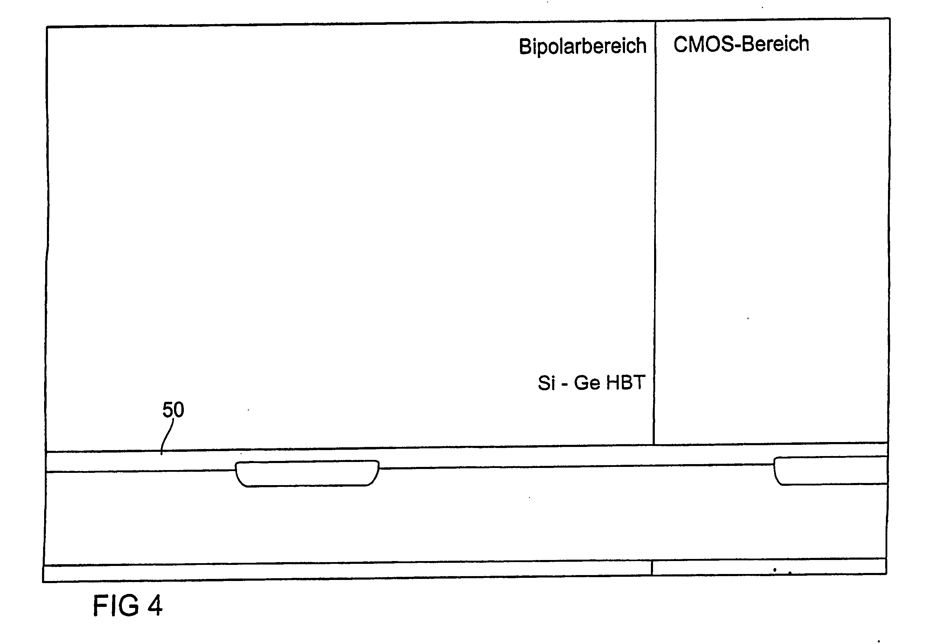

In einem nächsten Schritt wird dann die Oxidschicht 30 durch Naßätzung entfernt. Danach wird eine mit Arsen schwach n-dotierte Siliziumschicht 50 (Fig. 4) mit einer Dicke von vorzugsweise 600 nm epitaktisch aufgewachsen.

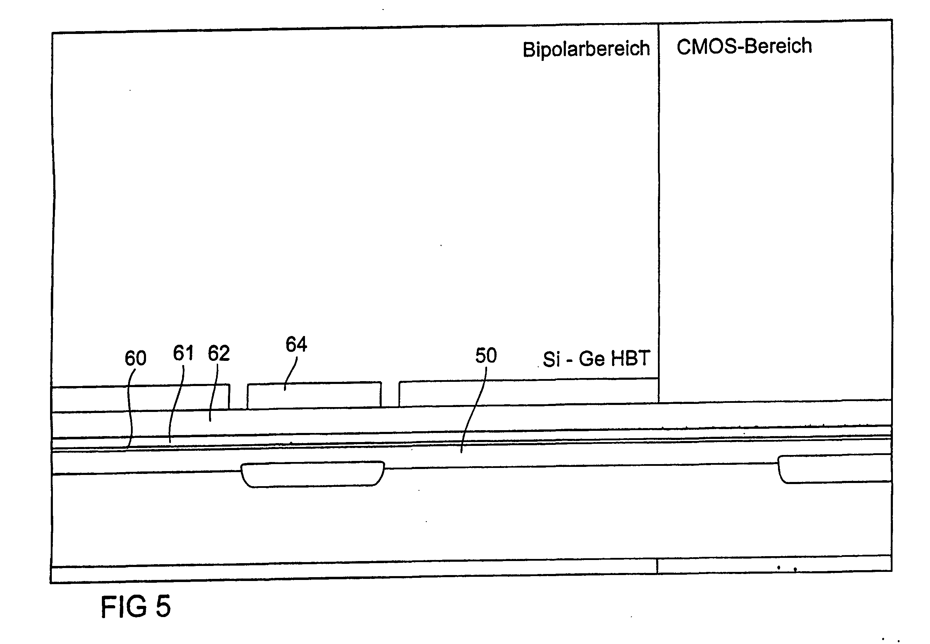

Wie es in Fig. 5 zu sehen ist, wird dann auf die Epitaxieschicht 50 zunächst ein Oxid 60 mit einer Dicke von vorzugsweise 5 nm aufgebracht. Dann wird ein Nitrid 61 aufgebracht, und zwar vorzugsweise mit einer Dicke von 100 nm. Dann folgt eine Oxidschicht, die vorzugsweise aus BPSG gebildet ist und in Fig. 5 mit dem Bezugszeichen 62 bezeichnet ist. Hierauf folgt ein Photolithographieschritt mit einer Maske 64, um die Oxidschicht 62 zu strukturieren, um Bereiche zu definieren, in denen tiefe Gräben gebildet werden sollen.

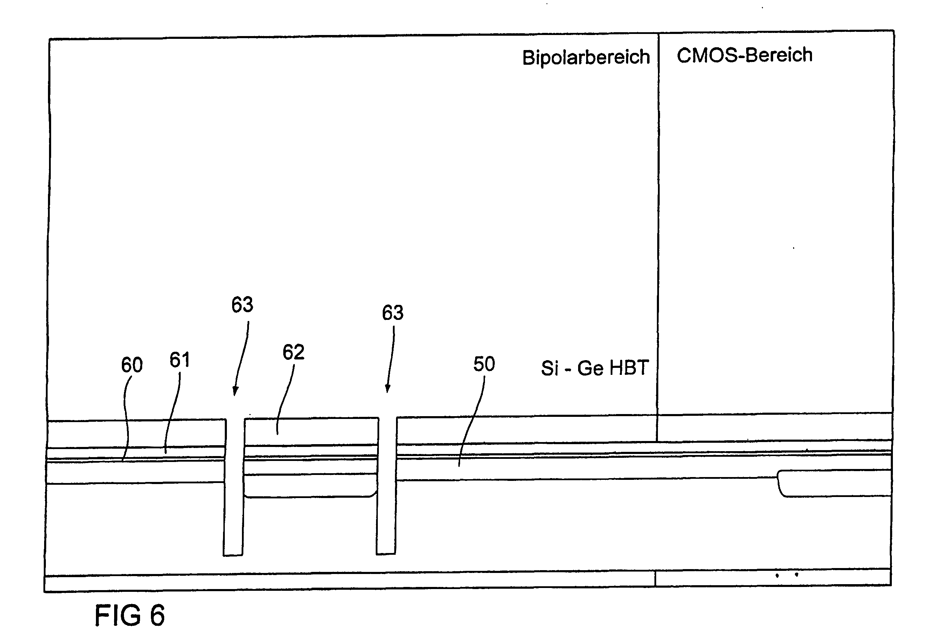

Gemäß der Lithographiemaske 64 wird dann das BPSG-Oxid geätzt, um Bereiche für die tiefen Gräben 63 in Fig. 6 in der Oxidschicht 62 zu erzeugen.

Dann wird der Photolack 64 entfernt und mit dem BPSG-Oxid 62 als Ätzmaske wird eine Ätzung durchgeführt, die sowohl durch die Nitridschicht 61 und die Oxidschicht 60 von Fig. 5 als auch durch das epitaktische Silizium 50 hindurch bis zu etwa einer Tiefe von 6 µm in das Halbleitersubstrat 12 hinein reicht, um zu der Struktur zu gelangen, die in Fig. 6 gezeigt ist.

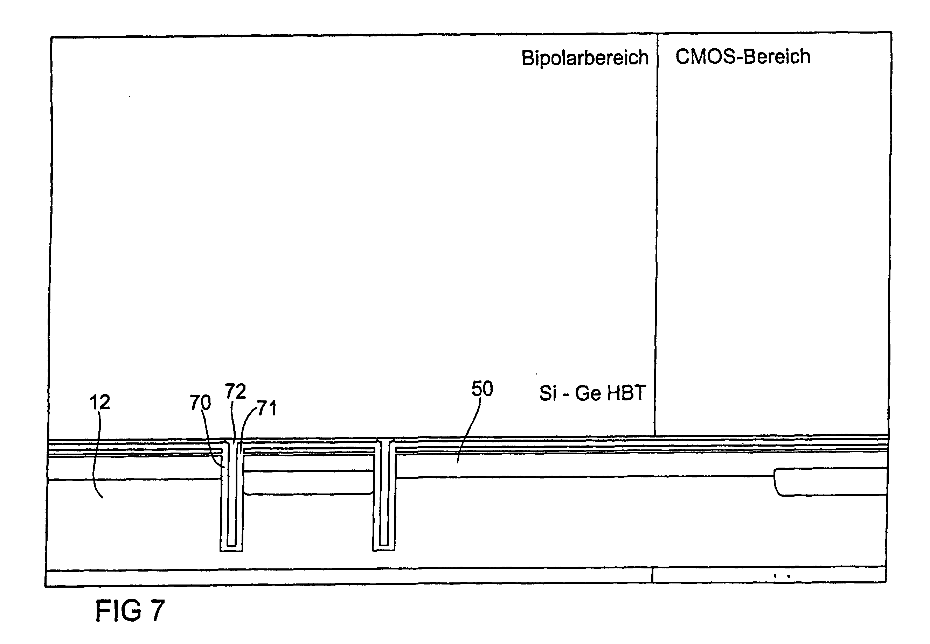

Hierauf wird, wie in Fig. 7 dargestellt, die BPSG-Maske 62 von Fig. 6 entfernt, um dann durch thermische Oxidation des Siliziums eine erste Oxidschicht 70 mit einer Dicke von vorzugsweise ca. 50 nm in den Gräben zu erzeugen, auf die dann etwa bis zu einer Dicke von 200 nm mittels CVD eine weitere Oxidschicht 71 aufgebracht wird. Anschließend wird auf die gesamte integrierte Schaltung und insbesondere in die Gräben hinein eine Polysiliziumschicht 72 aufgebracht, die auf der Oberfläche der integrierten Schaltung eine Dicke von etwa 150 nm erhalten soll.

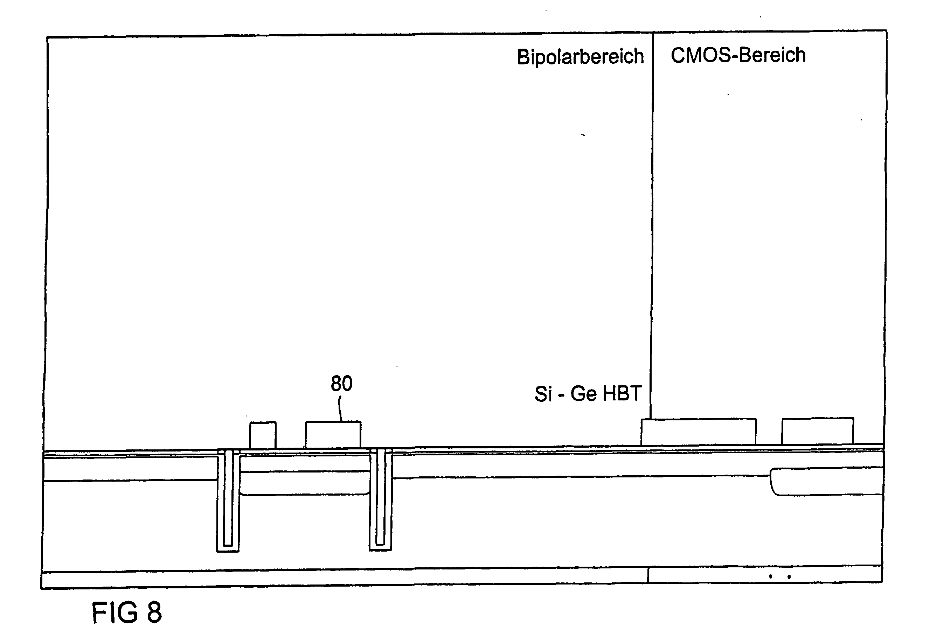

Wie es in Fig. 8 zu sehen ist, wird das Polysilizium 72 sowie die Oxidschicht 71 außerhalb der Gräben durch Plasmaätzen bzw. Naßätzen bis auf die darunter liegende Nitridschicht entfernt. Dann folgt ein Lithographieschritt, um eine Photolackmaske 80 zur Definition der flachen Grabenisolation zu erzeugen.

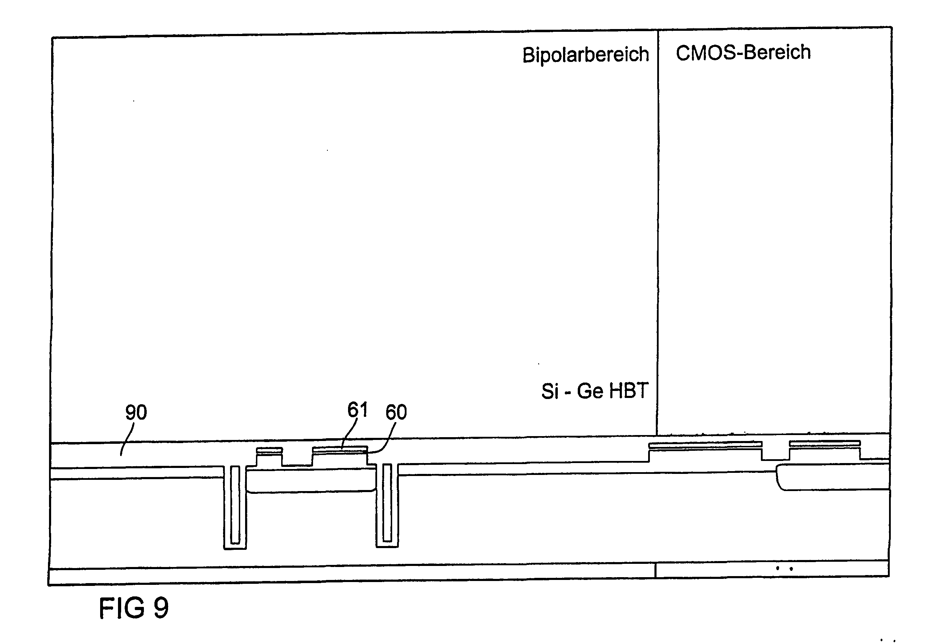

Um zu der Struktur, wie sie in Fig. 9 gezeigt ist, zu gelangen, wird dann abhängig von der Maske 80 von Fig. 8 eine Plasmaätzung der Nitridschicht 61 von Fig. 6 sowie der darunter liegenden Oxidschicht 60 durchgeführt, so daß lediglich die in Fig. 9 gezeigten Bereiche dieser Schichten 60 und 61 verbleiben. Das Ätzen ist ein nicht-selektives Plasmaätzen, abhängig, wie es bereits ausgeführt worden ist, von der Photolackmaske 80 von Fig. 8. Dann wird der Photolack entfernt. Hierauf wird in den Gräben ein thermisches Oxid mit einer Dicke von 10 nm erzeugt. Danach wird ein PECVD-Oxid mit einer Dicke von 500 nm aufgebracht. Schließlich wird ein chemischmechanisches Polieren durchgeführt, um zu der Struktur von Fig. 9 zu kommen, die sowohl den Bipolarbereich als auch den CMOS-Bereich betrifft. Die in diesem Abschnitt beschriebenen Schritte erzeugen die bekannte sog. "Shallow Trench Isolation". Selbstverständlich können auch andere Isolationsverfahren eingesetzt werden.

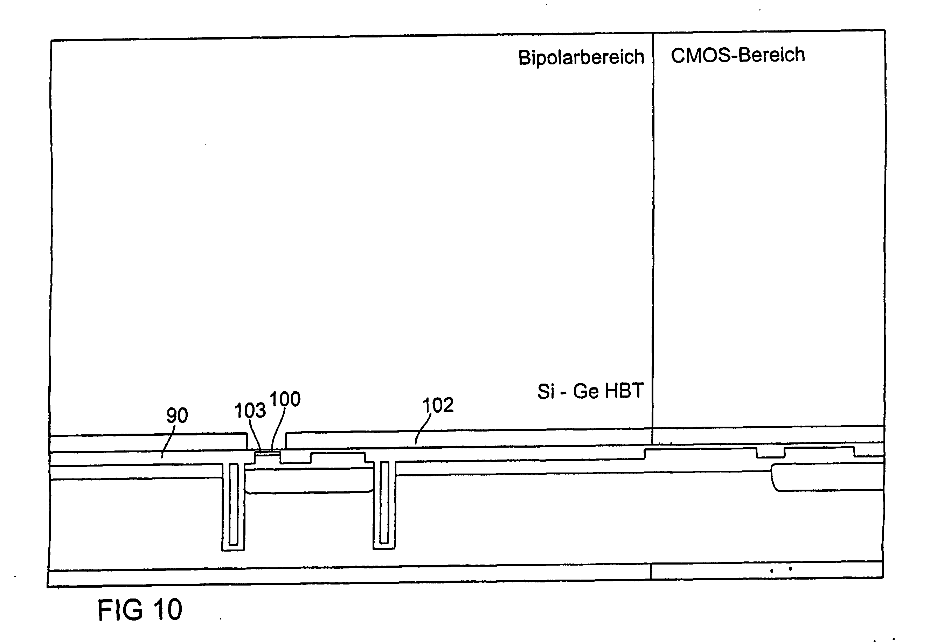

Daraufhin wird, wie es in Fig. 10 gezeigt ist, die Oxidschicht 90 von Fig. 9 geätzt. Diese Ätzung umfaßt ferner die Nitridschicht 61 und die unter dem Nitrid liegende Oxidschicht 60, so daß nur noch ein Teil der Oxidschicht 90 in Fig. 10 verbleibt. Auf den freien Siliziumflächen wird mittels thermischer Oxidation eine dünne Oxidschicht von ca. 7 nm erzeugt, die als Streuoxid für die folgende Implantation dient. Diese Schicht ist in Fig. 10 mit 100 bezeichnet. Daraufhin wird eine weitere Maske 102 erzeugt, um Bereiche zu definieren, in denen dann ein Donator, vorzugsweise Phosphor, mit sehr hoher Dosis von einigen 10¹⁵ cm⁻² implantiert wird.

Daraufhin wird der Photolack 102 wieder entfernt, und die Implantationen im Bereich 103 mittels einer thermischen Behandlung ausdiffundiert, um einen Kollektoranschlußbereich 110 zu schaffen. Daraufhin wird in einem weiteren Lithographieschritt eine weitere Maske 113 erzeugt, um die Bereiche der CMOS p-Wannen und der Isolationsgebiete zu definieren. Die nicht von Photolack bedeckten Flächen der integrierten Schaltung werden mit Bor implantiert, in einer Weise, daß die ursprüngliche niedrige n-Dotierung der Epitaxieschicht in den implantierten Gebieten vollständig überkompensiert wird. Dies führt dazu, daß sowohl Isolationsgebiete 114, 115 im Bipolarbereich als auch eine p-Wanne 116 im CMOS-Bereich erzeugt werden.

Nach der Implantation wird die Photolackmaske 113 wieder entfernt. Dann findet ein weiterer Lithographieschritt statt, um eine weitere Photolackmaske 120 zu bilden, die den gesamten Bipolarbereich abdeckt, und im CMOS-Bereich die n-Wannengebiete für die Implantation von Phosphor freiläßt.

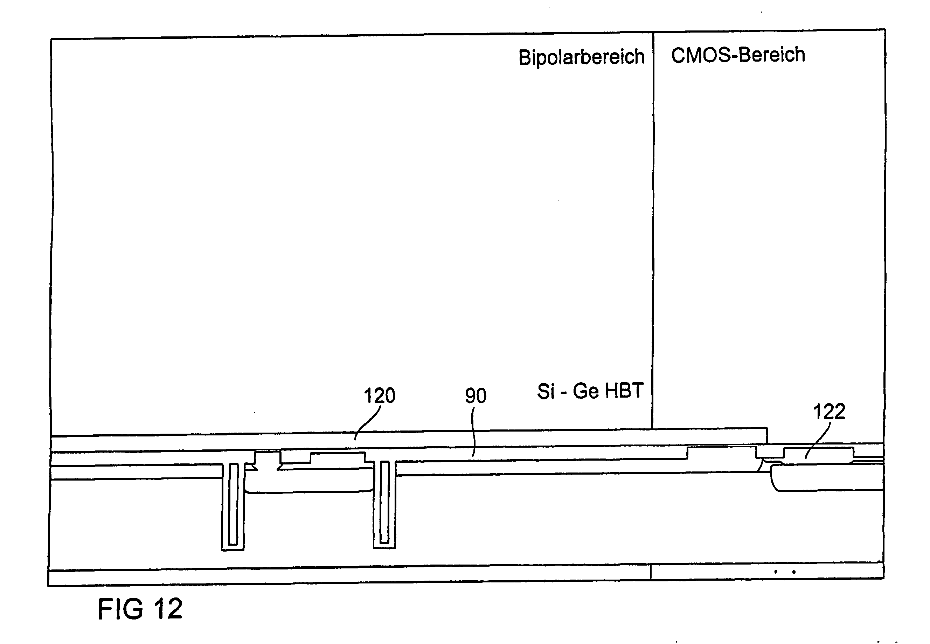

Nach der Phosphorimplantation wird die Photolackmaske 120 wieder entfernt. Die Oxidschicht 90, die z. B. in Fig. 12 gezeigt ist, wird mittels Naßätzung entfernt. Die freie Silizium-Oberfläche wird oxidiert, um eine dünne Oxidschicht 130 von ca. 5 nm Dicke zu erhalten, die im CMOS-Bereich als Gate-Oxid wirken wird. Auf die Gate-Oxid-Schicht wird ganzflächig undotiertes Polysilizium mittels eines LP-CVD-Verfahrens bis zu einer Dicke von vorzugsweise 100 nm aufgebracht. Die Polysiliziumschicht ist mit 131 bezeichnet. Auf der Polysiliziumschicht 131 wird ein CVD-Oxid vorzugsweise bis zu einer Dicke von 30 nm aufgebracht. Mittels einer Photolackmaske 132 wird nunmehr der gesamte Bereich der integrierten Schaltung abgedeckt, der nicht entweder einen Silizium-NPN-Bipolartransistor oder einen Silizium-Germanium-HBT umfaßt.

Es sei darauf hingewiesen, daß der guten Übersicht halber in den folgenden Figuren ein Bereich der Schaltung, in dem ein Bipolartransistor erzeugt wird, von einem Bereich der Schaltung, in dem ein HBT erzeugt wird, getrennt dargestellt ist. Mittels einer Plasmaätzung wird nunmehr die Oxidschicht 133 in den Transistorbereichen für BT und HBT entfernt.

Anschließend wird die Lackmaske 132 entfernt. Daraufhin wird eine Plasmaätzung der Polysiliziumschicht 131 durchgeführt. Diese Ätzung wird maskiert von der CVD-Oxidschicht 133 und stoppt auf dem Gateoxid 130.

Anschließend wird über der gesamten Schaltung ein Material für die spätere Platzhalterschicht im HBT abgeschieden, wobei dieses Material vorzugsweise ein CVD-Oxid ist. Die Platzhalterschicht ist im HBT-Bereich mit 150 bezeichnet. Darüber wird eine Nitridschicht 151 aufgebracht, die von einer Lithographiemaske 152 abgedeckt wird. Aus Fig. 15 ist zu sehen, daß die Maske 152 lediglich HBT-Bereiche abdeckt, nicht aber BT-Bereiche. Daraufhin wird eine Plasmaätzung der Nitridschicht 151 durchgeführt, so daß die Nitridschicht überall dort wieder entfernt wird, wo die Maske 152 nicht vorhanden ist.

Wie es aus Fig. 16 ersichtlich ist, wird die Maske 152 wieder entfernt. Daraufhin wird eine Oxidätzung durchgeführt, wobei für die Oxidätzung jedoch die Nitridschicht 151 als Maske wirkt. Dies führt dazu, daß die Oxidschicht 105 im Bipolarbereich entfernt wird, während sie im HBT-Bereich durch die Nitridschicht 151 geschützt wird und daher nicht entfernt wird, sondern als Platzhalterschicht verbleibt. Daraufhin wird, nach der Oxidätzung, mittels einer Naßätzung das Nitrid 151 entfernt, wobei als Ätzmittel vorzugsweise Phosphorsäure verwendet wird. Dies führt dazu, daß nunmehr im HBT-Bereich die Platzhalterschicht 150 vorhanden ist, während dieselbe im BT-Bereich nicht mehr vorhanden ist. Schließlich wird, wie es in Fig. 16 zu sehen ist, über der gesamten Schaltung undotiertes Polysilizium mittels eines LPCVD-Prozesses aufgebracht. Die Dicke der Polysiliziumschicht 160 beträgt vorzugsweise 150 nm. Diese Polysiliziumschicht wird später sowohl für den BT als auch für den HBT als Basiskontaktstruktur fungieren.

Nunmehr wird über der gesamten Schaltung mittels eines LPCVD-Prozesses eine Oxidschicht bis zu vorzugsweise einer Dicke von 55 nm aufgebracht. Daraufhin erfolgt ein Lithographieschritt, durch den eine Maske erzeugt wird, die im CMOS-Bereich die Gate-Kontakte definiert, und die im Bipolarbereich die aktiven Transistorbereiche von BT und HBT abdeckt.

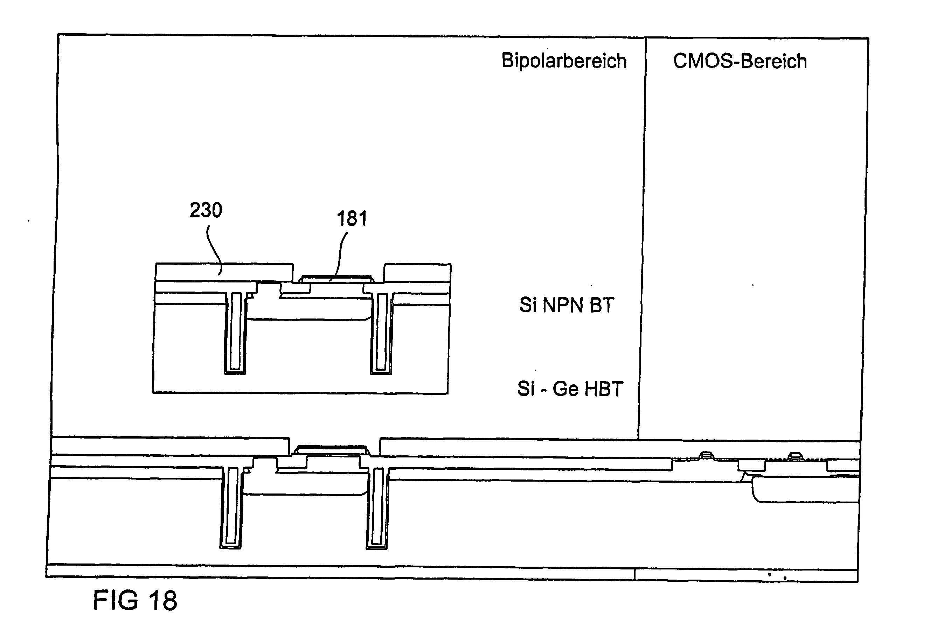

Mit der Lackmaske wird die Oxidschicht strukturiert, die dann nach Entfernen der Lackmaske ihrerseits als Maske für die Ätzung des Polysiliziums dient. So ergeben sich Gate-Kontakte 180 und die Basiskontaktstruktur 181 von Fig. 18.

In der Folge werden übliche Prozeßschritte zur Herstellung der CMOS-Transistoren durchgeführt: LDD-Implantationen, Erzeugung des Spacers und eine n+ Implantation für Source, Drain und Gate des n-Kanal Transistors.

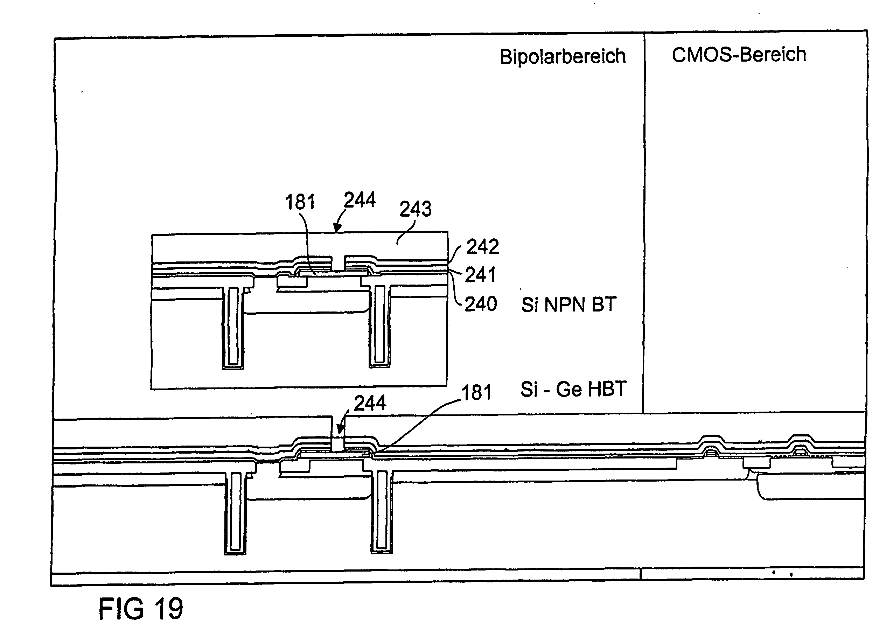

Danach wird eine Maske 230 aufgebracht, um Implantationsgebiete für die Implantation der Basiskontaktstruktur 181 sowohl des BT als auch des HBT zu definieren. Das undotierte Polysilizium der Basiskontaktstruktur 181 wird dann mit Bor implantiert. Die Maske 230 wird dann wieder entfernt, gefolgt von einer Reinigung. Daraufhin wird eine Mehrschichtstruktur aufgewachsen. Zunächst wird eine LPCVD-Nitridschicht mit vorzugsweise einer Dicke von 25 nm erzeugt, die in Fig. 19 mit 240 bezeichnet ist. Daraufhin wird eine LPCVD-TEOS-Schicht 241 vorzugsweise bis zu einer Dicke von 100 nm aufgebracht. Hierauf folgt eine weitere, jedoch nunmehr dickere LPCVD-Nitridschicht 242, die eine Dicke von vorzugsweise 100 nm hat. Daraufhin wird eine weitere Maske 243 aufgebracht, um Emitterfenster sowohl für den BT als auch für den HBT zu definieren. Die Emitterfenster 244 werden dann mittels einer Plasmaätzung, wie es in Fig. 19 gezeigt ist, bis zur Basiskontaktstruktur 181 geöffnet. Daraufhin wird die Maske 243 wieder entfernt. Nunmehr wird die Basiskontaktstruktur 181 von Fig. 19 plasmageätzt, so daß sie in dem Bereich der Emitterfenster 244 nicht mehr vorhanden ist. Die Plasmaätzung der Basiskontaktschicht 181 stoppt beim HBT auf der Platzhalterschicht 150. Beim Bipolartransistor wird die Silizium-Epitaxieschicht 50 leicht angeätzt. Daraufhin wird ein Streuoxid für die Basisimplantation aufgewachsen auf der monokristallinen Halbleiterschicht 50 des Bipolartransistors. Hierauf wird eine Implantation der Basis des Silizium-Bipolartransistors durchgeführt, wobei die Basis des Bipolartransistors mit einer p-Dotierung zu versehen ist. Die Implantationsenergie ist so gering, daß die Platzhalterschicht 150 im HBT nicht durchdrungen wird. Damit findet keine p-Dotierung des HBT statt, wohl aber eine p-Dotierung der Basis des Bipolartransistors, wobei die Basis des Bipolartransistors möglichst dünn werden soll, um einen schnellen Bipolartransistor zu erhalten.

Daraufhin findet ebenfalls durch das Emitterfenster 244 hindurch eine selektive Kollektorimplantation statt, um einen höher n-dotierten Bereich 251 sowohl im BT-Bereich als auch im HBT-Bereich zu erzeugen. Hierzu wird ein zweistufiges Implantationsverfahren verwendet, bei dem in beiden Stufen Phosphor eingesetzt wird. Es sei darauf hingewiesen, daß der Bereich 251 aus der Kollektorstruktur, der höher dotiert ist, für den Bipolartransistor in der Richtung senkrecht zur Oberfläche kürzer ist als für den Heterobipolartransistor, da die Basis des Bipolartransistors gewissermaßen in diesem Bereich gebildet ist, während die Basis des Heterobipolartransistors, wie es nachfolgend dargelegt werden wird, auf diesem Bereich 50 gebildet ist. Darüber hinaus ist es wichtig, daß der Bereich 251 dotiert wird, damit der Kollektorbahnwiderstand aufgrund des nicht so stark dotierten monokristallinen Siliziumbereichs 50 nicht zu groß wird.

Vorteilhaft an der erfindungsgemäßen Prozeßtechnologie ist, daß die selektive Kollektorimplantation mit hoher Energie durchgeführt werden kann, da Implantationsatome mit hoher Energie einfach in der vergrabenen Schicht 32 landen und dort ohne Bedeutung sind. Damit kann die unterschiedliche Länge des Bereichs 251 für BT und HBT ohne weiteres "ausgeglichen" werden.

Nach der Implantation der Basis des Bipolartransistors und der Kollektorbereiche des Bipolartransistors und des Heterobipolartransistors wird der Dotierungsverlauf der Basis 252 mittels eines Diffusionschrittes, vorzugsweise mit einem RTP-Prozeß, eingestellt.

Nach dem Ausheilen wird eine LPCVD-Nitridschicht mit vorzugsweise einer Dicke von 50 nm aufgebracht, die mit 260 bezeichnet ist. Auf die LPCVD-Nitridschicht 260 wird ferner eine LPCVD-TEOS-Schicht 262 gebracht. Mittels eines Fotolithographieschrittes wird eine Lackmaske 264 erzeugt, die den Bipolartransistor abdeckt, während der HBT nicht abgedeckt wird. Dann wird die TEOS-Schicht 262 abhängig von der Maske aus dem HBT-Bereich herausgeätzt, so daß nur noch die Nitridschicht 260 im Emitterfenster des HBT verbleibt, aus der schließlich Nitrid-Spacer entstehen werden.

Hierauf wird die Maske 264 wieder entfernt, und es folgt eine Plasmaätzung des Nitrids 260 in den Bereichen, wo es nicht mehr durch die Oxidschicht 262 bedeckt ist, um das Nitrid in die in Fig. 22 gezeigte Form zu bringen. Anschließend wird eine Naßätzung mit Flußsäure durchgeführt, um die Platzhalterschicht 150 aus dem HBT herauszuätzen. Dabei wird gleichzeitig die Oxidschicht 262 überall entfernt, wo sie noch vorhanden war. Auf das Emitterfenster 244 des Bipolartransistors hat diese Naßätzung keine Auswirkung, da am Boden des Emitterfensters des Bipolartransistors eine Nitridschicht vorhanden ist, die durch die Naßätzung zum Entfernen der Platzhalterschicht nicht angegriffen wird.

Bei dem in Fig. 22 gezeigten Prozeßstand wird eine selektive epitaktische Abscheidung von Silizium-Germanium vorgenommen. Bei diesem Prozeßschritt lagert sich nur auf freiliegenden mono- oder polykristallinen Silizium-Oberflächen Material an. Deshalb erfolgt die Schichtabscheidung nur in dem von der Platzhalterschicht 150 befreiten Bereich. Hier bildet sich die Silizium-Germanium-Basis 280 des HBT. Die SiGe-Epi wächst auch auf der freiliegenden Unterseite des Basis-Anschluß-Poly an und stellt damit den Basiskontakt her.

Nach der Silizium-Germanium-Epitaxie von Fig. 18 wird eine Nitridätzung durchgeführt, um die Nitridschichten 260 im Bipolarbereich und im HBT-Bereich zu entfernen. Hierauf findet ein HF-Dip der integrierten Schaltungsstruktur statt, um auch das Streuoxid unter der Nitridschicht 260 von Fig. 21, das in Fig. 20 mit 250 bezeichnet ist, zu entfernen.

Fig. 23 zeigt somit die integrierte Schaltung in einem Zustand, bei dem sowohl die p-Basis 250 als auch die Silizium-Germanium-Basis 280 freiliegend sind. Die Struktur in Fig. 23 ist somit sowohl für den Bipolartransistor als auch für den Heterobipolartransistör in demselben Ausgangszustand, so daß nunmehr identische Verarbeitungsschritte für beide Transistorarten durchgeführt werden können, um die Transistoren durch Herstellung der Emitterstruktur zu vollenden.

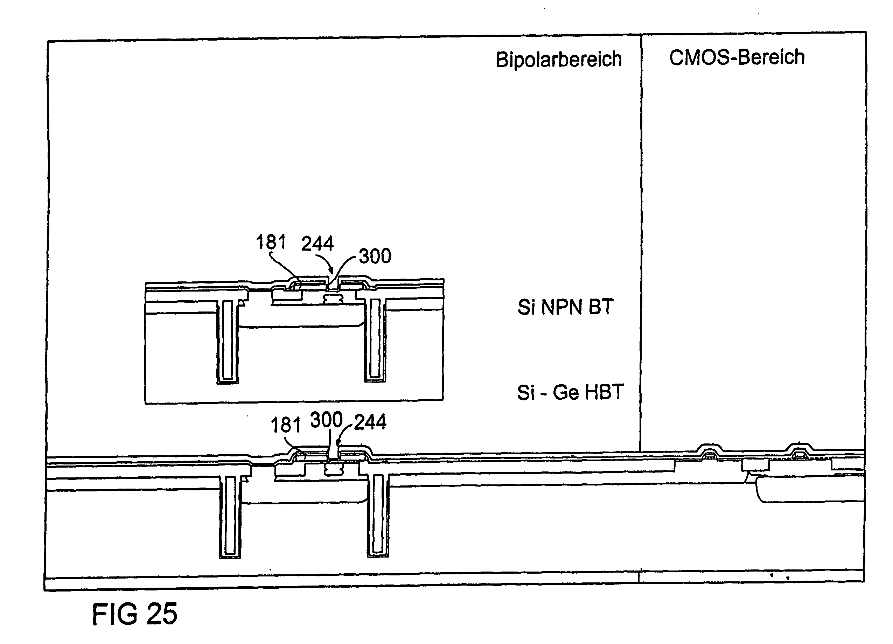

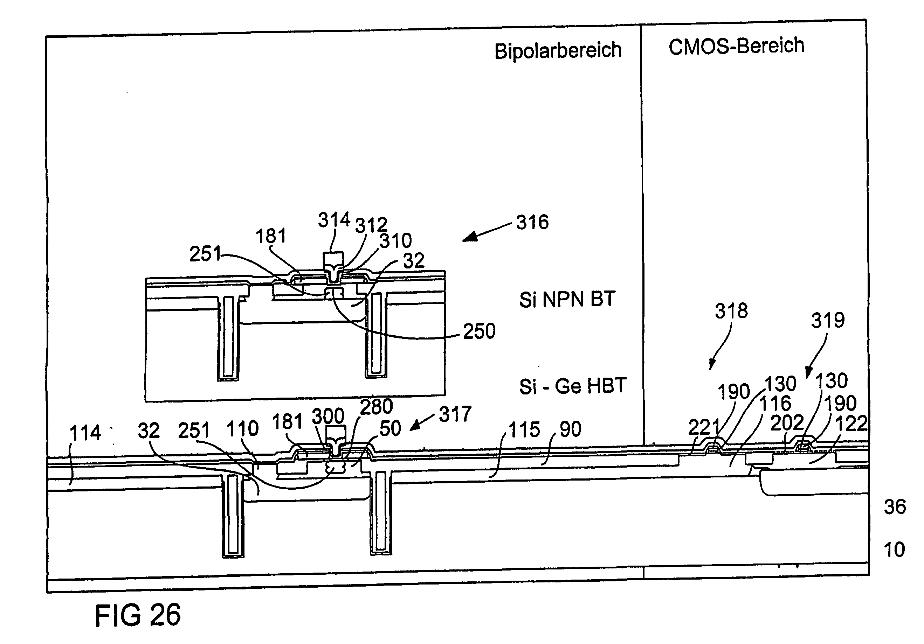

Hierzu wird auf die Schaltung zunächst ein LPCVD-TEOS mit einer Dicke von 55 nm aufgebracht, was in einer Schicht 290 resultiert. Dann wird ein LPCVD-Nitrid mit einer Dicke von 100 nm aufgebracht, was dazu führt, daß die gesamte Schaltung mit Nitrid abgedeckt wird. Eine anschließende Plasmaätzung entfernt die Nitridschicht vollständig bis auf verbleibende Seitenwandspacer 292 an steilen Stufen, insbesondere an den Wänden der Emitterfenster sowohl im Bipolartransistor als auch im HBT. Mit einer Flußsäureätzung wird die Oxidschicht 290 überall dort entfernt, wo sie nicht mehr von Nitrid bedeckt ist. Dadurch bleiben in den Emitterfenstern L-förmige (im Querschnitt betrachtet) Oxidspacer 300. Dieser Spacer dient zur Isolation der Basiskontaktstruktur 181 von der Bezug nehmend auf Fig. 26 erläuterten noch zu erstellenden Emitterstruktur. Die Nitridspacer haben ihren Zweck erfüllt und werden mittels einer Phosphorsäureätzung entfernt. Die resultierende Struktur ist in Fig. 25 dargestellt.

Hierauf wird als Emitterkontakt und Emitter-Dotierstoffquelle ein mit Arsen dotiertes LPCVD-Polysilizium 312 aufgebracht und mit einem Lithographieschritt mit Maske 314 mittels Plasmaätzung strukturiert. Die beiden Transistoren sind nunmehr fertiggestellt, bis auf die nun noch zu erfolgende Verdrahtung und unmittelbare Kontaktierung des Emitters, der Basis und des Kollektors des Transistors.

Im nachfolgenden werden anhand von Fig. 26 sowohl der Bipolartransistor 316 als auch der Heterobipolartransistor 317 im Bipolarbereich sowie der erste Feldeffekttransistor 318, der ein p-Kanal-Feldeffekttransistor ist, als auch der zweite Feldeffekttransistor 319, der ein n-Kanal-Transistor ist, zusammenfassend beschrieben.

Die Kollektorstruktur sowohl des Silizium-npn-Bipolartransistors als auch des Silizium-Germanium-Heterobipolartransistors besteht aus der vergrabenen Schicht 32, die höher n-dotiert ist. Aus Fig. 26 ist daher zu sehen, daß die Kollektorbereiche sowohl des Bipolartransistors als auch des HBT aus denselben Herstellungsschichten gebildet sind.

Der Heterobipolartransistor umfaßt eine Silizium-Germanium-Basis 280, während der Bipolartransistor eine p-dotierte Silizium-Basis 250 aufweist.

Die Emitterstrukturen für beide Transistoren sind wieder aus identischen Herstellungsschichten ausgebildet. Sie umfassen zunächst den L-Spacer 300 im Emitterfenster. Der eigentliche Emitter ist durch die Grenzfläche der Schicht 310 und der darunter liegenden Basis 250 bzw. 300 gegeben.

Im CMOS-Bereich findet man wie üblich zwei Transistortypen: Der erste Transistor 318 liegt in einer p-Wanne 116, ist ein n-Kanal-Transistor und umfaßt Source/Drain-Gebiete 221, ein Gate-Oxid 130 sowie die Gate-Elektrode aus Polysilizium mit einer hoch n-dotierten oberen Schicht zur Kontaktierung.

Der zweite Feldeffekttransistor 319 ist dagegen ein p-Kanal-Feldeffekttransistor mit einer n-Wanne 122, p-dotierten Source/Drain-Gebieten 202, einem Gate-Oxid 130 und einem Gate-Kontakt 190.

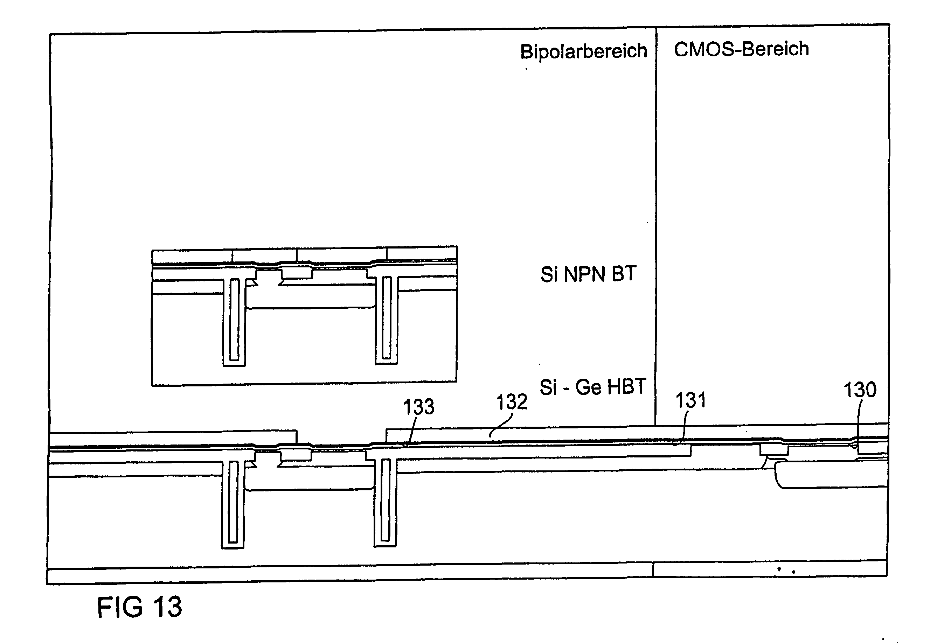

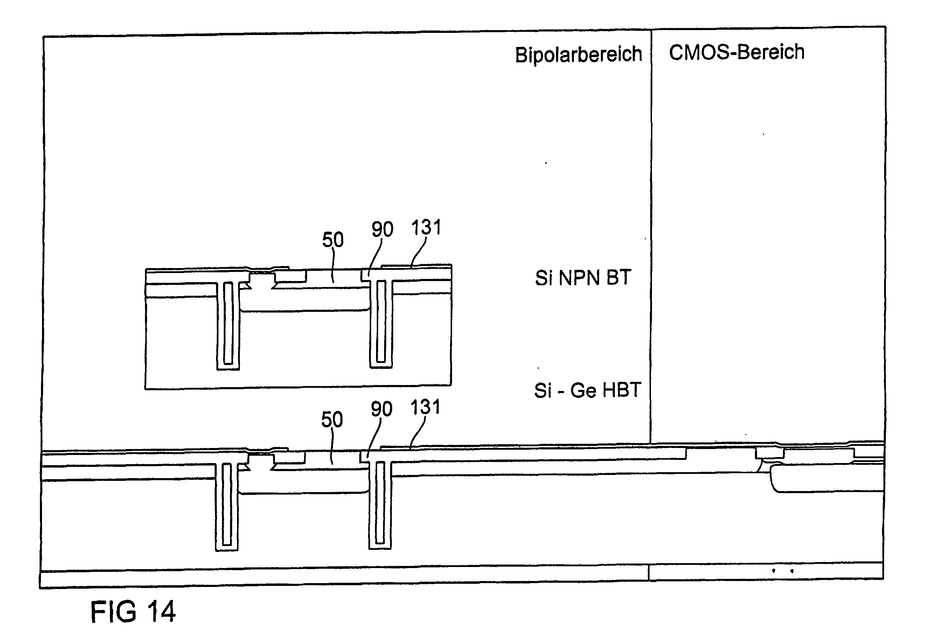

Im nachfolgenden werden noch einmal die wesentlichen Schritte in Gruppen strukturiert zusammengefaßt. Die Fig. 1 bis 13 zeigen einen BiCMOS-Prozeß, der zwischen Bipolartransistor und Heterobipolartransistor noch keinen Unterschied macht. In Fig. 13 wird dann die erste Schicht des sogenannten Split-Polysiliziums, also des Zweifach-Polysiliziums, für das CMOS-Gate aufgebracht. In den Fig. 13 und 14 ist ferner ein Lithographieschritt dargestellt, um die erste Schicht der Split-Polysiliziumschicht auf den aktiven Bereichen (Emitter-Basis) des Bipolartransistors und des HBT zu entfernen. In Fig. 15 ist das Aufbringen einer TEOS-Schicht mit einer Dicke von etwa 120 nm gezeigt, wobei diese Schicht 150 als Platzhalterschicht wirken wird, wenn, nach einer Entfernung dieser Schicht in einem späteren Schritt die selektive Silizium-Germanium-Epitaxie in den HBT-Basisbereichen durchgeführt wird.

In Fig. 15 ist ein Lithographieschritt zum Strukturieren der TEOS-Platzhalterschicht gezeigt, um diese in den aktiven Bereichen der Bipolartransistoren wieder zu entfernen.

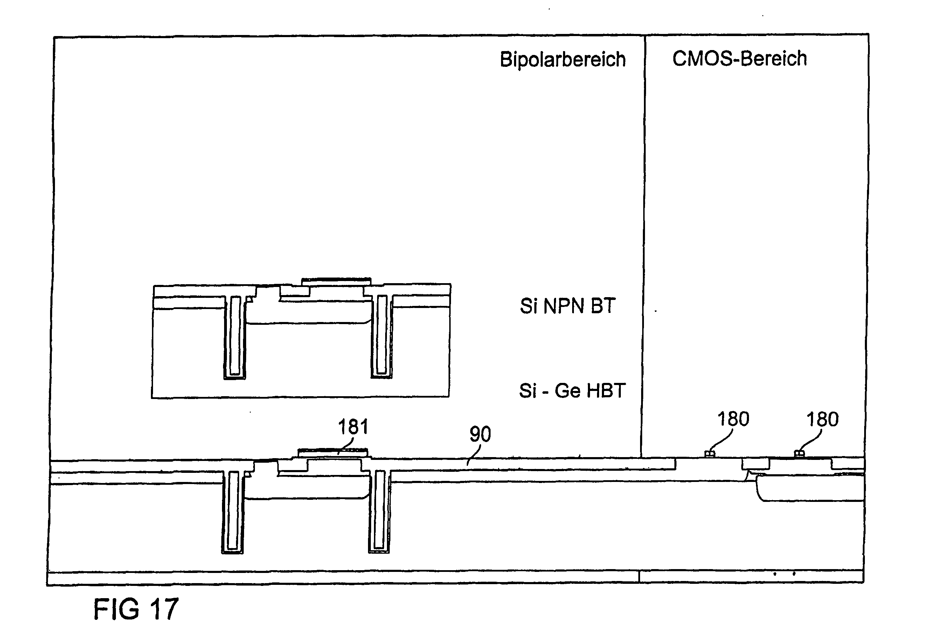

In Fig. 16 wird die obere Schicht der Split-Polysilizium-Struktur aufgebracht. Anhand der Fig. 17 wird die Lithographie für die CMOS-Gates und wird der CMOS-Prozeßblock zur Herstellung des ersten und des zweiten Feldeffekttransistors gezeigt.

In Fig. 18 ist die starke Bor-Implantation der Basiskontakt-Polysiliziumschicht 121 für beide Transistortypen gezeigt.

In Fig. 19 wird für beide Transistortypen das Emitterfenster geöffnet, und zwar mit demselben Lithographieschritt und mit derselben Ätzung.

In Fig. 20 wird das Streuoxid für die Bipolartransistor-Basisimplantation aufgebracht. In Fig. 20 ist ferner die Implantation der Kollektorstruktur gezeigt, wobei optional eine Maskierung für Hochspannungstransistoren durchgeführt werden kann.

In Fig. 20 ist ferner die Basisimplantation für den Bipolartransistor gezeigt, wobei als Maske für den Silizium-Germanium-Heterobipolartransistor eine TEOS-Schicht vorhanden ist.

Fig. 20 bezieht sich ferner auf das Ausheilen der Basis des Silizium-Bipolartransistors als auch der Kollektorbereiche beider Transistortypen.

In Fig. 21 ist eine Nitridabdeckungsschicht vor der selektiven Epitaxie gezeigt.

In Fig. 21 ist ferner die Strukturierung einer Oxidhartmaske gezeigt, welche dazu dient, bei der in Fig. 22 dargestellten anisotropen Nitridätzung zur Erzeugung von Nitrid-Spacern im Emitterfenster der Silizium-Germanium-Heterobipolartransistoren, die Nitridätzung im Emitterfenster der Silizium-Bipolartransistoren zu verhindern.

Fig. 22 bezieht sich ferner auf eine Naßätzung der TEOS-Schicht, wobei die Hartmaske entfernt wird, und wobei ferner die Platzhalterschicht entfernt wird, um schließlich eine Silizium-Germanium-Epitaxie im Emitterfenster und in einem kleinen Bereich unter dem Basiskontakt-Polysilizium 181 zu erreichen.

Die selektive Silizium-Germanium-Epitaxie findet dann in Fig. 23 statt. In Fig. 23 findet ferner eine Naßätzung der Nitridschicht statt, welche zur Abdeckung aller Gebiete diente, auf denen die Abscheidung der epitaktischen Schicht verhindert werden sollte.

In Fig. 24 und 25 sind die Prozeßschritte dargestellt, die einen L-Spacer für beide Transistortypen gleichzeitig erzeugen. Die Emitterpolysiliziumabscheidung und Strukturierung, die Bezug nehmend auf Fig. 26 erläutert worden ist, findet wiederum für beide Transistoren gleichzeitig statt.

Ein Vorteil der vorliegenden Erfindung besteht darin, daß sie eine reduzierte Prozeßkomplexität für die gleichzeitige Integration von klassischen Bipolartransistoren und Heterobipolartransistoren liefert, wobei dieses Konzept ferner, wie es ausgeführt worden ist, für einen BiCMOS-Prozeß kompatibel ist.

Insbesondere vorteilhaft ist, daß dieselbe Basiskontaktschicht 181 für beide Transistortypen eingesetzt werden kann. Nachdem die erste Schicht des Split-Polysilizium-Prozesses, die auf dem Gateoxid aufgebracht ist, in den aktiven Bereichen der Bipolartransistoren (Fig. 14) geöffnet worden ist, wird die TEOS-Platzhalterschicht 150 aufgebracht, die dazu dient, das Basiskontaktpolysilizium von dem monokristallinen Siliziumsubstrat im Silizium-Germanium-HBT zu trennen. Zur Strukturierung dieser Platzhalterschicht wird, wie es Bezug nehmend auf Fig. 15 dargelegt worden ist, ein Lithographieschritt benötigt.

Ein weiterer Vorteil der vorliegenden Erfindung besteht darin, daß dieselbe Kollektor-Implantation für beide Transistortypen durchgeführt werden kann (Fig. 20). Dies wird dadurch vorteilhaft erreicht, daß zwei oder drei Implantationen auf eine Art und Weise eingestellt werden, daß eine homogene Tiefenverteilung der Dotierstoffe resultiert. Der höher energetische Teil wird für den Silizium-Germanium-Transistor eingestellt und führt dazu, daß Dotieratome in der vergrabenen Schicht des Silizium-Bipolartransistors aufgenommen werden, was unkritisch ist. Die Implantation mit niedriger Energie wird bezüglich der Tiefe des Basis-Kollektor-Übergangs des Silizium-npn-Bipolartransistors eingestellt und wird teilweise in der TEOS-Platzhalterschicht des HBT absorbiert. In beiden Fällen treten keine schädlichen Effekte auf die elektrischen Eigenschaften der Transistoren auf.

Ein weiterer Vorteil der vorliegenden Erfindung besteht darin, daß dieselbe Nitridschicht, die verwendet worden ist, um die Seitenwandspacer an der Basisstruktur 181 des HBT zu erzeugen, auch dazu verwendet wird, daß der Emitterbereich des klassischen Bipolartransistors während der selektiven SiGe-Epitaxie bedeckt wird. Um diese Nitridschicht im Emitterbereich des Bipolartransistors zu schützen, während das Emitterfenster des HBT geätzt wird, werden der Lithographieschritt von Fig. 21 und eine Oxidhartmaske eingesetzt.

Schließlich ist die vorliegende Erfindung dahingehend vorteilhaft, daß dieselben Spacer (Fig. 24, 25) und dieselbe Emitter-Polysilizium-Schicht (Fig. 26) für beide Transistortypen verwendet werden können.

Ein Vorteil der vorliegenden Erfindung besteht darin, daß die Herstellungskosten für einen Prozeßfluß mit sowohl HBT als auch BT minimiert werden. Die Vorteile der erfindungsgemäßen Technologie bestehen darin, daß die Verwendung der Ertragskritischen Silizium-Germanium-HBTs auf Fälle begrenzt werden kann, wo die Schnelligkeit der Heterobipolartransistortechnik tatsächlich benötigt wird.

Durch einen möglichst großen Einsatz von klassischen Bipolartransistoren können die überlegenen Matching-Eigenschaften dieser Transistoren ausgenutzt werden, um Chipfläche zu sparen und um den Ertrag zu verbessern.

### Bezugszeichenliste

- 10: p-Silizium-Substrat
- 12: Oxidschicht
- 30: Oxidschicht
- 32: Implantation für vergrabene Kollektorschicht
- 34: Implantation für vergrabene Schicht unter n-Wanne
- 36: Photolackmaske
- 50: Silizium-Epitaxieschicht
- 60: Pad-Oxid
- 61: Nitrid
- 62: Oxid-Hartmaske
- 63: Grabenbereichsdefinition
- 64: Maske
- 70: erste Graben-Oxidschicht
- 71: zweite Graben-Oxidschicht
- 72: Polysiliziumschicht
- 80: Photolackmaske
- 90: Oxidschicht
- 100: Streuoxidschicht
- 102: Photolackmaske
- 103: Kollektorkontaktimplantation
- 110: Kollektorkontaktbereich
- 113: Photolack
- 114: p-dotierter Bereich
- 115: p-dotierter Bereich
- 116: p-Wanne
- 120: Photolack
- 122: n-Wanne
- 130: Gateoxid
- 131: Polysiliziumschicht
- 132: Photolack
- 133: TEOS-Oxid
- 150: Platzhalterschicht (TEOS)
- 151: Nitridschicht
- 152: Photolack
- 160: Polysiliziumschicht
- 180: Gate-Kontakt
- 181: Basiskontaktschicht
- 230: Photolackmaske
- 240: Nitridschicht
- 241: Oxidschicht
- 242: Nitridschicht
- 243: Photolackmaske
- 244: Emitterfenster
- 250: Streuoxid
- 251: dotierter Bereich der Kollektorstruktur
- 252: Basis des Bipolartransistors
- 260: Nitridschicht
- 262: Oxidschicht
- 264: Photolackmaske
- 270: Nitrid-Spacer
- 280: Basis des Heterobipolartransistors
- 290: Oxidschicht
- 292: Emitterfensterspacer
- 300: Emitterfenster-L-Spacer
- 310: erste Polysiliziumschicht (undotiert)
- 312: zweite Polysiliziumschicht (Arsen-dotiert)
- 314: Photolackmaske
- 316: Bipolartransistor
- 317: Heterobipolartransistor
- 318: n-Kanal-Feldeffekttransistor
- 319: p-Kanal-Feldeffekttransistor
- 320: Schritt des Strukturierens
- 322: Schritt des Erzeugens der Platzhalterschicht
- 324: Schritt des Erzeugens der Basis des Bipolartransistors
- 326: Schritt des Abdeckens der Basis des Bipolartransistors
- 328: Schritt des Erzeugens der Basis des Heterobipolartransistors
- 330: Schritt des Erzeugens der gemeinsamen Emitterstruktur

## Patentansprüche

1. Verfahren zum Herstellen einer integrierten Schaltung, die einen Bipolartransistor (316) mit einer Basis (250) aus einem ersten Halbleitermaterial und einen Heterobipolartransistor (317) mit einer Basis (280) aus einem zweiten Halbleitermaterial aufweist, mit folgenden Merkmalen:
Strukturieren (320) eines Halbleitersubstrats (10) aus einem ersten Halbleitermaterial, um Kollektorstrukturen (32, 50, 110, 251) für den Bipolartransistor (316) und den Heterobipolartransistor (317) zu erzeugen;
Erzeugen (322) einer Platzhalterschicht (150)in einem Basisbereich des Heterobipolartransistors, wobei die Platzhalterschicht in einem Basisbereich des Bipolartransistors nicht vorhanden ist;
Erzeugen (324) einer Basis (250) des Bipolartransistors, wobei die Platzhalterschicht (150) in dem Basisbereich des Heterobipolartransistors vorhanden ist, durch
Erzeugen von Emitterfenstern (244) für den Heterobipolartransistor und den Bipolartransistor, wobei sich das Emitterfenster (244) für den Heterobipolartransistor bis zur Platzhalterschicht (150) erstreckt, und wobei sich das Emitterfenster (244) für den Bipolartransistor bis zur Kollektorstruktur erstreckt, und
durch Implantation auf die Kollektorstruktur des Bipolartransistors und die Platzhalterschicht durch die Emitterfenster (244), wobei die Implantation so eingestellt ist, dass die Platzhalterschicht von einem Implantatiionsmaterial im wesentlichen nicht durchdrungen wird, und wobei die Implantation eine Implantation gemäß einem zweiten Dotierungstyp ist, der sich von einem ersten Dotierungstyp, mit dem die Kollektorstruktur dotiert ist, unterscheidet;
nach dem Schritt des Erzeugens der Basis des Bipolartransistors, Erzeugen einer selektiven Kollektor implantationsstruktur (251) durch Implantieren auf die Kollektorstruktur des Bipolartransistors und die Platzhalterschicht durch die Emitterfenster, wobei der Schritt des Implantierens so eingestellt ist, dass die Platzhalterschicht von einem Implantationsmaterial durchdrungen wird, und wobei die Implantation eine Implantation gemäß dem ersten Dotierungstyp ist,
nach dem Schritt des Implantierens, Abdecken (326) der Basis des Bipolartransistors und Entfernen der Platzhalterschicht (150);
Erzeugen (328) der Basis (280) des Heterobipolartransistors aus dem zweiten Halbleitermaterial in einem Bereich, aus dem die Platzhalterschicht (150) entfernt worden ist; und
Erzeugen (330) von Emitterstrukturen (300, 310, 312) für den Bipolartransistor und den Heterobipolartransistor.

2. Verfahren nach Anspruch 1, bei dem der Schritt (320) des Erzeugens der Kollektorstrukturen für den Bipolartransistor und den Heterobipolartransistor folgende Teilschritte aufweist:
Bilden einer vergrabenen Schicht (32), die eine Dotierung eines ersten Dotierungstyps mit einer ersten Dotierungskonzentration aufweist, auf der ein oberer Bereich (251) gebildet ist, der eine Dotierung des ersten Dotierungstyps mit einer zweiten Dotierungskonzentration aufweist, wobei die zweite Dotierungskonzentration niedriger als die erste Dotierungskonzentration ist;
Isolieren der vergrabenen Schicht von dem umgebenden Halbleitersubstrat durch einen Graben; und
Kontaktieren (110) der vergrabenen Schicht, um eine Kontaktierung für einen Kollektorkontakt des Bipolartransistors oder des Heterobipolartransistors zu schaffen.

3. Verfahren nach Anspruch 1 oder 2, bei dem der Schritt des Erzeugens (322) der Platzhalterschicht (150) folgende Teilschritte aufweist:
Freilegen des Basisbereichs des Bipolartransistors und des Heterobipolartransistors;
Aufbringen der Platzhalterschicht (150) auf den Basisbereichen;
Maskieren (152) des Basisbereichs des Heterobipolartransistors und Entfernen der Platzhalterschicht von dem Basisbereich des Bipolartransistors.

4. Verfahren nach einem der vorhergehenden Schritte, bei dem nach dem Schritt (322) des Erzeugens der Platzhalterschicht eine Schicht (181) aus einem dritten Halbleitermaterial zum Kontaktieren der Basis des Bipolartransistors bzw. der Basis des Heterobipolartransistors auf die Platzhalterschicht bzw. auf die Kollektorstruktur des Bipolartransistors aufgebracht wird.

5. Verfahren nach Anspruch 4, bei dem die Schicht aus dem dritten Halbleitermaterial (181) behandelt wird, um eine Dotierung gemäß einem zweiten Dotierungstyp zu erreichen.

6. Verfahren nach Anspruch 5, bei dem eine Schicht aus drittem Halbleitermaterial vorhanden ist, wobei die Schicht (181) vor dem Erzeugen der Emitterfenster implantiert wird, wobei das Verfahren ferner folgenden Schritt aufweist:
Ausbilden der integrierten Schaltung,
um die Schicht aus drittem Halbleitermaterial (181) auf eine Dotierung mit dem zweiten Dotierungstyp zu bringen,
um die Basis (250) des Bipolartransistors auf eine Dotierung mit dem zweiten Dotierungstyp zu bringen, und
um den einen Bereich der Kollektorstruktur für den Bipolartransistor und den Heterobipolartransistor auf eine Dotierung mit dem ersten Dotierungstyp zu bringen.

7. Verfahren nach einem der vorhergehenden Ansprüche, bei dem der Schritt des Erzeugens (322) einer Basis des Bipolartransistors und der Schritt des Entfernens (322) der Platzhalterschicht folgende Schritte aufweist:
Einbringen einer Schutzstruktur (260, 262) in ein Emitterfenster (244) des Bipolartransistors;
Auffüllen der Emitterfenster (244) sowohl für den Bipolartransistor als auch für den Heterobipolartransistor;
Maskieren (264) des Bipolartransistors;
Öffnen des Emitterfensters (244) des Heterobipolartransistors;
Erzeugen einer seitlichen Abdeckung (260) im Emitterfenster des Heterobipolartransistors; und
Herausätzen der Platzhalterschicht (150) über das Emitterfenster des Heterobipolartransistors so, dass die seitli-che Abdeckung (260) verbleibt, und dass die Schutzstruktur (260) in dem Emitterfenster (244) des Bipolartransistors verbleibt.

8. Verfahren nach einem der vorhergehenden Schritte, bei dem der Schritt (328) des Erzeugens einer Basis des Heterobipolartransistors folgende Schritte aufweist:
selektives epitaxiales Aufwachsen des zweiten Halbleitermaterials in dem Emitterfenster des Heterobipolartransistors; und
Entfernen der Schutzstruktur (260) aus dem Emitterfenster des Bipolartransistors.

9. Verfahren nach einem der vorhergehenden Ansprüche, bei dem der Schritt (330) des Erzeugens von Emitterstrukturen folgende Schritte aufweist:
Passivieren (290) der Emitterfenster (244) des Heterobipolartransistors und des Bipolartransistors;
Erzeugen (292) einer seitlichen Abdeckung für die Emitterfenster des Bipolartransistors und des Heterobipolartransistors;
Einbringen (310, 312) eines vierten Halbleitermaterials in die Emitterfenster (244) des Bipolartransistors und des Heterobipolartransistors; und
Strukturieren (314) des vierten Halbleitermaterials, um die Emitterstruktur zu erhalten.

10. Verfahren nach Anspruch 9, bei dem der Schritt des Einbringens des vierten Halbleitermaterials folgende Schritte aufweist:
Aufbringen des vierten Halbleitermaterials in undotiertem Zustand;
teilweises Ätzen des undotierten Halbleitermaterials;
Aufbringen des vierten Halbleitermaterials im dotierten Zustand;
Maskieren (314), um die Emitterstruktur zu definieren;
Ätzen der integrierten Schaltung, so daß die Emitterstruktur verbleibt.

11. Verfahren nach einem der vorhergehenden Ansprüche, bei dem die integrierte Schaltung ferner eine CMOS-Struktur mit einem ersten Feldeffekttransistor (318) eines ersten Typs und einem zweiten Feldeffekttransistor (319) eines zweiten Typs umfasst.

12. Verfahren nach Anspruch 11, bei dem in dem Schritt des Strukturierens eine erste Wanne (116) und eine Gate-Isolation (130) für den ersten Feldeffekttransistor sowie eine Wanne (122) und eine Gate-Isolation (130) für den zweiten Feldeffekttransistor hergestellt werden.

13. Verfahren nach Anspruch 11 oder 12,
bei dem vor dem Erzeugen der Platzhalterschicht ein Halbleitermaterial für die Gate-Kontakte (190) des ersten und des zweiten Feldeffekttransistors aufgebracht werden, und
bei dem im Schritt des Erzeugens der Platzhalterschicht das Halbleitermaterial für die Gate-Kontakte aus den Basisbereichen des Bipolartransistors und des Heterobipolartransistors entfernt wird.

14. Verfahren nach einem der Ansprüche 11 bis 13,
bei dem die Gate-Kontakte des ersten und des zweiten Feldeffekttransistors nach dem Erzeugen der Platzhalterschicht (150) strukturiert werden.

15. Verfahren nach einem der Ansprüche 11 bis 14,
bei dem Source/Drain-Bereiche (202, 221) vor dem Erzeugen der Basis des Bipolartransistors definiert werden, wobei der Feldeffekttransistor ein NMOS-Transistor ist.

16. Integrierte Schaltung mit folgenden Merkmalen:
einem Halbleitersubstrat mit Schichten;
einem Bipolartransistor (316) in dem Halbleitersubstrat; und
einem Heterobipolartransistor (317) in dem Halbleitersubstrat,
wobei Kollektorstrukturen (32, 50, 110, 251) des Bipolartransistors (316) und des Heterobipolartransistors (317) und/oder Emitterstrukturen (300, 310, 312) des Bipolartransistors (316) und des Heterobipolartransistors (317) in unterschiedlichen Bereichen der integrierten Schaltung aus identischen Schichten des Halbleitersubstrats gebildet sind, und
wobei die Kollektorstrukturen des Bipoltransistors und des Heterobipoltransistors folgende Merkmale aufweisen:
eine vergrabene Schicht (32);
einen Kollektoranschlussbereich (110);
eine obere Schicht (50) auf der vergrabenen Schicht (32), die schwächer als- die vergrabene Schicht (32) dotiert ist, und
einen Bereich (251) in der oberen Schicht (50), der stärker als die obere Schicht (50) dotiert ist.

17. Integrierte Schaltung nach Anspruch 16,
bei der eine Basis (280) des Heterobipolartransistors auf einer oberen Schicht (50) der Kollektorstruktur aufgebracht ist, und
bei der eine Basis (250) des Bipolartransistors (316) durch einen dotierten Bereich in der oberen Schicht (50) der Kollektorstruktur ausgeführt ist, so dass eine Kollektorlänge des Heterobipolartransistors größer als eine Kollektorlänge des Bipolartransistors ist.

18. Integrierte Schaltung nach Anspruch 16 oder 17,
bei der eine Basiskontaktierungsschicht (181) durch ein polykristallines Halbleitermaterial gebildet ist, wobei die Basiskontaktierungsschicht (181) für den Bipolartransistor (316) und den Heterobipolartransistor (317) aus einer identischen Schicht des Halbleitersubstrats in unterschiedlichen Bereichen des Halbleitersubstrats gebildet ist.

19. Integrierte Schaltung nach einem der Ansprüche 16 bis 18, bei der die Emitterstrukturen für den Bipolartransistor und den Heterobipolartransistor folgende Merkmale aufweisen:
eine seitliche Abdeckung (300) für ein Emitterfenster;
ein polykristallines Halbleitermaterial (310, 312) in dem Emitterfenster; und
einen Kontaktbereich, in dem das polykristalline Halbleitermaterial mit der Basis (250) des Bipolartransistors bzw. der Basis (280) des Heterobipolartransistors in Kontakt steht.

20. Integrierte Schaltung nach einem der Ansprüche 16 bis 19,
bei der eine Basis (280) des Heterobipolartransistors epitaktisch aufgewachsenes Halbleitermaterial umfasst, das sich von dem Halbleitermaterial unterscheidet, aus dem eine Basis (250) des Bipolartransistors gebildet ist.

21. Integrierte Schaltung nach Anspruch 18,
bei der für den Bipolartransistor (316) die Basiskontaktierungsschicht (181) auf einer oberen Schicht (50) der Kollektorstruktur aufgebracht ist, und
bei der für den Heterobipolartransistor die Basiskontaktierungsschicht auf einer Isolatorschicht aufgebracht ist, die auf der oberen Schicht der Kollektorstruktur angeordnet ist.

22. Integrierte Schaltung nach einem der Patentansprüche 16 bis 21, die ferner eine CMOS-Struktur mit einem ersten Feldeffekttransistor (318) und einem zweiten Feldeffekttransistor (319) aufweist.

## Claims

1. Method for manufacturing an integrated circuit comprising a bipolar transistor (316) having a base (250) of a first semiconductor material and a hetero bipolar transistor (317) having a base (280) of a second semiconductor material, the method comprising:
structuring (320) a semiconductor substrate (10) of a first semiconductor material to generate collector structures (32, 50, 110, 251) for the bipolar transistor (316) and the hetero bipolar transistor (317);
generating (322) a placeholder layer (150) in a base region of the hetero bipolar transistor, wherein the placeholder layer is not present in a base region of the bipolar transistor;
generating (324) a base (250) of the bipolar transistor, wherein the placeholder layer (150) is present in the base region of the hetero bipolar transistor, by
generating emitter windows (244) for the hetero bipolar transistor and the bipolar transistor, wherein the emitter window (244) for the hetero bipolar transistor extends as far as the placeholder layer (150), and wherein the emitter window (244) for the bipolar transistor extends as far as the collector structure, and
by implantation on the collector structure of the bipolar transistor and the placeholder layer through the emitter windows (244), wherein the implantation is adjusted so that the placeholder layer is substantially not penetrated by an implantation material, and wherein the implantation is an implantation according to a second doping type which differs from a first doping type with which the collector structure is doped;
after the step of generating the base of the bipolar transistor, generating a selective collector implantation structure (251) by implanting on the collector structure of the bipolar transistor and the placeholder layer through the emitter windows, wherein the step of implanting is adjusted so that the placeholder layer is penetrated by an implantation material, and wherein the implantation is an implantation according to the first doping type,
after the step of implanting, covering (326) the base of the bipolar transistor and removing the placeholder layer (150);
generating (328) the base (280) of the hetero bipolar transistor of the second semiconductor material in a region from which the placeholder layer (150) has been removed; and
generating (330) emitter structures (300, 310, 312) for the bipolar transistor and the hetero bipolar transistor.

2. Method of claim 1, wherein the step (320) of generating the collector structures for the bipolar transistor and the hetero bipolar transistor comprises the following sub-steps:
forming a buried layer (32) having a doping of a first doping type with a first doping concentration, on which an upper region (251) is formed having a doping of the first doping type with a second doping concentration, wherein the second doping concentration is lower than the first doping concentration;
isolating the buried layer from the surrounding semiconductor substrate by a trench; and
contacting (110) the buried layer to provide contacting for a collector contact of the bipolar transistor or the hetero bipolar transistor.

3. Method of claim 1 or 2, wherein the step of generating (322) the placeholder layer (150) comprises the following sub-steps:
exposing the base region of the bipolar transistor and the hetero bipolar transistor;
applying the placeholder layer (150) to the base regions;
masking (152) the base region of the hetero bipolar transistor and removing the placeholder layer from the base region of the bipolar transistor;

4. Method of one of the preceding steps, wherein, after the step (322) of generating the placeholder layer, a layer (181) of a third semiconductor material is applied to the placeholder layer or the collector structure of the bipolar transistor for contacting the base of the bipolar transistor or the base of the hetero bipolar transistor.

5. Method of claim 4, wherein the layer of the third semiconductor material (181) is treated to achieve a doping according to a second doping type.

6. Method of claim 5, wherein a layer of a third semiconductor material is present, wherein the layer (181) is implanted prior to generating the emitter windows, wherein the method further comprises the following step:
forming the integrated circuit,
to give the layer of third semiconductor material (181) a doping with the second doping type,
to give the base (250) of the bipolar transistor a doping with the second doping type, and
to give the region of the collector structure for the bipolar transistor and the hetero bipolar transistor a doping with the first doping type.

7. Method of one of the preceding claims, wherein the step of generating (322) a base of the bipolar transistor and the step of removing (322) the placeholder layer comprise the following steps:
inserting a protective structure (260, 262) into an emitter window (244) of the bipolar transistor;
filling the emitter windows (244) both for the bipolar transistor and for the hetero bipolar transistor;
masking (264) the bipolar transistor;
opening the emitter window (244) of the hetero bipolar transistor;
generating a side cover (260) in the emitter window of the hetero bipolar transistor; and
etching out the placeholder layer (150) via the emitter window of the hetero bipolar transistor so that the side cover (260) remains and that the protective structure (260) remains in the emitter window (244) of the bipolar transistor.

8. Method of one of the preceding steps, wherein the step (328) of generating a base of the hetero bipolar transistor comprises the following steps:
selective epitaxial growing of the second semiconductor material in the emitter window of the hetero bipolar transistor; and
removing the protective structure (260) from the emitter window of the bipolar transistor.

9. Method of one of the preceding claims, wherein the step (330) of generating emitter structures comprises the following steps:
passivating (290) the emitter windows (244) of the hetero bipolar transistor and the bipolar transistor;
generating (292) a side cover for the emitter windows of the bipolar transistor and the hetero bipolar transistor;
inserting (310, 312) a fourth semiconductor material into the emitter windows (244) of the bipolar transistor and the hetero bipolar transistor; and
structuring (314) the fourth semiconductor material to obtain the emitter structure.

10. Method of claim 9, wherein the step of inserting the fourth semiconductor material comprises the following steps:
applying the fourth semiconductor material in undoped state;
partially etching the undoped semiconductor material;
applying the fourth semiconductor material in doped state;
masking (314) to define the emitter structure;
etching the integrated circuit so that the emitter structure remains.

11. Method of one of the preceding claims, wherein the integrated circuit further includes a CMOS structure with a first field-effect transistor (318) of a first type and a second field-effect transistor (319) of a second type.

12. Method of claim 11, wherein, in the step of structuring, a first well (116) and a gate isolation (130) for the first field-effect transistor as well as a well (122) and a gate isolation (130) for the second field-effect transistor are produced.

13. Method of claim 11 or 12,
wherein, prior to generating the placeholder layer, a semiconductor material for the gate contacts (190) of the first and second field-effect transistors is applied, and
wherein, in the step of generating the placeholder layer, the semiconductor material for the gate contacts is removed from the base regions of the bipolar transistor and the hetero bipolar transistor.

14. Method of one of claims 11 to 13,
wherein the gate contacts of the first and second field-effect transistors are structured after generating the placeholder layer (150).

15. Method of one of claims 11 to 14,
wherein source/drain regions (202, 221) are defined prior to generating the base of the bipolar transistor, wherein the field-effect transistor is an NMOS transistor.

16. Integrated circuit, comprising:
a semiconductor substrate with layers;
a bipolar transistor (316) in the semiconductor substrate; and
a hetero bipolar transistor (317) in the semiconductor substrate,
wherein collector structures (32, 50, 110, 251) of the bipolar transistor (316) and the hetero bipolar transistor (317) and/or emitter structures (300, 310, 312) of the bipolar transistor (316) and the hetero bipolar transistor (317) are formed in different regions of the integrated circuit, of identical layers of the semiconductor substrate, and
wherein the collector structures of the bipolar transistor and the hetero bipolar transistor comprise:
a buried layer (32);
a collector terminal region (110);
an upper layer (50) on the buried layer (32), which is lower doped than the buried layer (32), and
a region (251) in the upper layer (50), which is higher doped than the upper layer (50).

17. Integrated circuit of claim 16,
wherein a base (280) of the hetero bipolar transistor is applied to an upper layer (50) of the collector structure, and
wherein a base (250) of the bipolar transistor (316) is implemented by a doped region in the upper layer (50) of the collector structure so that a collector length of the hetero bipolar transistor is greater than a collector length of the bipolar transistor.

18. Integrated circuit of claim 16 or 17,
wherein a base contacting layer (181) is formed by a polycrystalline semiconductor material, wherein the base contacting layer (181) for the bipolar transistor (316) and the hetero bipolar transistor (317) is formed of an identical layer of the semiconductor substrate in different regions of the semiconductor substrate.

19. Integrated circuit of one of claims 16 to 18, wherein the emitter structures for the bipolar transistor and the hetero bipolar transistor comprise:
a side cover (300) for an emitter window;
a polycrystalline semiconductor material (310, 312) in the emitter window; and
a contact region in which the polycrystalline semiconductor material is in contact with the base (250) of the bipolar transistor or the base (280) of the hetero bipolar transistor.

20. Integrated circuit of one of claims 16 to 19,
wherein a base (280) of the hetero bipolar transistor includes epitaxially grown semiconductor material that differs from the semiconductor material of which a base (250) of the bipolar transistor is formed.

21. Integrated circuit of claim 18,
wherein, for the bipolar transistor (316), the base contacting layer (181) is applied to an upper layer (50) of the collector structure, and
wherein, for the hetero bipolar transistor, the base contacting layer is applied to an isolator layer which is located on the upper layer of the collector structure.

22. Integrated circuit of one of claims 16 to 21, further comprising a CMOS structure with a first field-effect transistor (318) and a second field-effect transistor (319).

## Revendications

1. Procédé de production d'un circuit intégré qui comporte un transistor (316) bipolaire ayant une base (250) en un premier matériau semi-conducteur et un transistor (317) hétérobipolaire ayant une base (280) en un deuxième matériau semi-conducteur, comprenant les stades suivants dans lesquels :
on structure (320) un substrat (10) semi-conducteur en un premier matériau semi-conducteur pour produire des structures (32, 50, 110, 251) de collecteur pour le transistor (316) bipolaire et pour le transistor (317) hétérobipolaire ;
on produit (322) une couche (150) de maintien à distance dans une zone de base du transistor hétérobipolaire, la couche de maintien à distance n'étant pas présente dans une zone de base du transistor bipolaire ;
on produit (324) une base (250) du transistor bipolaire, la couche (150) de maintien à distance étant présente dans la zone de base du transistor hétérobipolaire par
production de fenêtres (244) pour le transistor hétérobipolaire et pour le transistor bipolaire, la fenêtre (244) d'émetteur pour le transistor hétérobipolaire allant jusqu'à la couche (150) de maintien à distance et la fenêtre (244) d'émetteur pour le transistor bipolaire allant jusqu'à la structure de collecteur, et
par implantation sur la structure de collecteur du transistor bipolaire et sur la couche de maintien à distance en passant par la fenêtre (244) d'émetteur, l'implantation étant réglée de façon à ce que la couche de maintien à distance ne soit sensiblement pas traversée par un matériau d'implantation, et l'implantation étant une implantation suivant un deuxième type de dopage qui se distingue d'un premier type de dopage par lequel la structure de collecteur est dopée ;
après le stade de production de la base du transistor bipolaire, on produit une structure (251) d'implantation de collecteur sélective en implantant sur la structure de collecteur du transistor bipolaire et sur la couche de maintien à distance en passant par la fenêtre d'émetteur, le stade d'implantation étant réglé de façon à ce que la couche de maintien à distance soit traversée par un matériau d'implantation et l'implantation étant une implantation suivant le premier type de dopage,
après le stade de l'implantation, on revêt (326) la base du transistor bipolaire et on élimine la couche (150) de maintien à distance ;
on produit (328) la base (280) du transistor hétérobipolaire en le deuxième matériau semi-conducteur dans une zone dont la couche (150) de maintien à distance a été éliminée ;
on produit (330) des structures (300, 310, 312) d'émetteur pour le transistor bipolaire et pour le transistor hétérobipolaire.

2. Procédé suivant la revendication 1, dans lequel le stade (320) de production des structures de collecteur pour le transistor bipolaire et pour le transistor hétérobipolaire comporte les sous-stades suivants :
on forme une couche (32) enterrée qui a un dopage d'un premier type de dopage ayant une première concentration de dopage sur laquelle on forme une zone (251) supérieure qui a un dopage du premier type de dopage ayant une deuxième concentration de dopage, la deuxième concentration de dopage étant plus petite que la première concentration de dopage ;
on isole la couche enterrée du substrat semi-conducteur qui est autour par un sillon ; et
on met (110) en contact la couche enterrée pour ménager un contact pour un contact de collecteur du transistor bipolaire ou du transistor hétérobipolaire.

3. Procédé suivant la revendication 1 ou 2, dans lequel le stade de production (322) de la couche (150) de maintien à distance comporte les sous-stades suivants :
on met à nu la zone de base du transistor bipolaire et du transistor hétérobipolaire ;
on dépose la couche (150) de maintien à distance sur les zones de base ;
on masque (152) la zone de base du transistor hétérobipolaire et on élimine la couche de maintien à distance de la zone de base du transistor bipolaire.

4. Procédé suivant l'une des revendications précédentes, dans lequel après le stade (322) de production de la couche de maintien à distance, on dépose une couche (181) en un troisième matériau semi-conducteur pour mettre en contact la base du transistor bipolaire ou la base du transistor hétérobipolaire sur la couche de maintien à distance ou sur la structure de collecteur du transistor bipolaire.

5. Procédé suivant la revendication 4, dans lequel on traite la couche en le troisième matériau (181) semi-conducteur pour obtenir un dopage suivant un deuxième type de dopage.

6. Procédé suivant la revendication 5, dans lequel une couche en le troisième matériau semi-conducteur est présente, la couche (181) étant implantée avant la production de la fenêtre d'émetteur, le procédé comprenant en outre les stades suivants :
on constitue le circuit intégré,
pour mettre la couche en le troisième matériau (181) semi-conducteur sur un dopage ayant le deuxième type de dopage,
pour mettre la base (250) du transistor bipolaire sur un dopage ayant le deuxième type de dopage, et
pour mettre l'une des zones de la structure de collecteur pour le transistor bipolaire et le transistor hétérobipolaire sur un dopage ayant le premier type de dopage.

7. Procédé suivant l'une des revendications précédentes, dans lequel le stade de production (322) d'une base du transistor bipolaire et le stade d'élimination (322) de la couche de maintien à distance comportent les stades suivants :
on introduit une structure (260, 262) de protection dans une fenêtre (244) d'émetteur du transistor bipolaire ;
on remplit la fenêtre (244) d'émetteur tant pour le transistor bipolaire que pour le transistor hétérobipolaire ;
on masque (264) le transistor bipolaire ;
on ouvre la fenêtre (244) d'émetteur du transistor hétérobipolaire ;
on produit un revêtement (260) latéral dans la fenêtre d'émetteur du transistor hétérobipolaire ; et
on enlève par attaque la couche (150) de maintien à distance au-dessus de la fenêtre d'émetteur du transistor hétérobipolaire, de façon à laisser subsister le revêtement (260) latéral et de façon à laisser subsister la structure (260) de protection dans la fenêtre (244) d'émetteur du transistor bipolaire.

8. Procédé suivant l'une des revendications précédentes, dans lequel le stade (328) de production d'une base du transistor hétérobipolaire comporte les stades suivants :
on fait croître sélectivement par épitaxie le deuxième matériau semi-conducteur dans la fenêtre d'émetteur du transistor hétérobipolaire ; et
on élimine la structure (260) de protection de la fenêtre d'émetteur du transistor bipolaire.

9. Procédé suivant l'une des revendications précédentes, dans lequel le stade (330) de production de structures d'émetteur comporte les stades suivants :
on passive (290) la fenêtre (244) d'émetteur du transistor hétérobipolaire et du transistor bipolaire ;
on produit (292) un revêtement latéral de la fenêtre d'émetteur du transistor bipolaire et du transistor hétérobipolaire ;
on introduit (310, 312) un quatrième matériau semi-conducteur dans la fenêtre (244) d'émetteur du transistor bipolaire et du transistor hétérobipolaire ;
on structure (314) le quatrième matériau semi-conducteur pour obtenir la structure d'émetteur.

10. Procédé suivant la revendication 9, dans lequel le stade d'introduction du quatrième matériau semi-conducteur comporte les stades suivants :
on dépose le quatrième matériau semi-conducteur à l'état non dopé ;
on attaque en partie le matériau semi-conducteur non dopé ;
on dépose le quatrième matériau conducteur à l'état dopé ;
on masque (314) pour définir la structure d'émetteur ;
on attaque le circuit intégré de manière à laisser subsister la structure d'émetteur.

11. Procédé suivant l'une des revendications précédentes, dans lequel le circuit intégré comprend en outre une structure CMOS ayant un premier transistor (318) à effet de champ d'un premier type et un deuxième transistor (319) à effet de champ d'un deuxième type.

12. Procédé suivant la revendication 11, dans lequel, dans le stade de la structuration, on produit un premier caisson (116) et une isolation (130) de grille pour le premier transistor à effet de champ, ainsi qu'un caisson (122) et une isolation (130) de grille pour le deuxième transistor à effet de champ.

13. Procédé suivant la revendication 11 ou 12,
dans lequel, avant la production de la couche de maintien à distance, on dépose un matériau semi-conducteur pour les contacts (190) de grille du premier et du deuxième transistor à effet de champ, et
dans lequel, dans le stade de la production de la couche de maintien à distance, on élimine le matériau semi-conducteur pour les contacts de grille des zones de base du transistor bipolaire et du transistor hétérobipolaire.

14. Procédé suivant l'une des revendications 11 à 13,
dans lequel on structure les contacts de grille du premier et du deuxième transistor à effet de champ après la production de la couche (150) de maintien à distance.

15. Procédé suivant l'une des revendications 11 à 14,
dans lequel on définit des zones (202, 221) de source/drain avant la production de la base du transistor bipolaire, le transistor à effet de champ étant un transistor NMOS.

16. Circuit intégré ayant les caractéristiques suivantes :
un substrat semi-conducteur ayant des couches ;
un transistor (316) bipolaire dans le substrat semi-conducteur ; et
un transistor (317) hétérobipolaire dans le substrat semi-conducteur,
des structures (32, 50, 110, 251) de collecteur du transistor (316) bipolaire et du transistor (317) hétérobipolaire et/ou des structures (300, 310, 312) d'émetteur du transistor (316) bipolaire et du transistor (317) hétérobipolaire étant formées dans des zones différentes du circuit intégré constitué de couches identiques du substrat semi-conducteur, et
dans lequel les structures de collecteur du transistor bipolaire et du transistor hétérobipolaire ont les caractéristiques suivantes :
une couche (32) enterrée ;
une zone (110) de borne de collecteur ;
une couche (50) supérieure qui est sur la couche (32) enterrée et qui est moins dopée que la couche (32) enterrée, et
une zone (251) de la couche (50) supérieure qui est plus dopée que la couche (50) supérieure.

17. Circuit intégré suivant la revendication 16,
dans lequel une base (280) du transistor hétérobipolaire est déposée sur une couche (50) supérieure de la structure de collecteur, et
dans lequel une base (250) du transistor (316) bipolaire est réalisée par une zone dopée de la couche (50) supérieure de la structure de collecteur, de sorte qu'une longueur de collecteur du transistor hétérobipolaire est plus grande qu'une longueur de collecteur du transistor bipolaire.

18. Circuit intégré suivant la revendication 16 ou 17,
dans lequel une couche (181) de mise en contact de la base est formée d'un matériau semi-conducteur polycristallin, la couche (181) de mise en contact de la base du transistor (316) bipolaire et du transistor (317) hétérobipolaire étant formée d'une couche identique du substrat semi-conducteur dans des zones différentes du substrat semi-conducteur.

19. Circuit intégré suivant l'une des revendications 16 à 18,
dans lequel les structures d'émetteur du transistor bipolaire et du transistor hétérobipolaire ont les caractéristiques suivantes :
un revêtement (300) latéral de la fenêtre d'émetteur ;
un matériau (310, 312) semi-conducteur polycristallin dans la fenêtre d'émetteur ; et
une zone de contact dans laquelle le matériau semi-conducteur polycristallin est en contact avec la base (250) du transistor bipolaire et avec la base (280) du transistor hétérobipolaire.

20. Circuit intégré suivant l'une des revendications 16 à 19,
dans lequel une base (280) du transistor hétérobipolaire comprend du matériau semi-conducteur que l'on a fait croître par épitaxie et qui se distingue du matériau semi-conducteur dont est formée une base (250) du transistor bipolaire.

21. Circuit intégré suivant la revendication 18,
dans lequel, pour le transistor (316) bipolaire, la couche (181) de mise en contact de la base est déposée sur une couche (50) supérieure de la structure de collecteur, et
dans lequel, pour le transistor hétérobipolaire, la couche de mise en contact de la base est déposée sur une couche d'isolement qui est placée sur la couche supérieure de la structure de collecteur.

22. Circuit intégré suivant l'une des revendications 16 à 21, qui comprend en outre une structure CMOS ayant un premier transistor (318) à effet de champ et un deuxième transistor (319) à effet de champ.
